# EUROPEAN PATENT APPLICATION

(11) **EP 4 561 274 A1**
(43) Date of publication of application: **28.05.2025**
(21) Application number: 23843447.6
(22) Date of filing: 24.07.2023
(51) Int. Cl.: H05K 3/28, H05K 1/11, H05K 3/40, H01L 23/31, H01L 23/498, H01L 25/10

(54) **CIRCUIT BOARD AND SEMICONDUCTOR PACKAGE COMPRISING SAME**

(30) Priority: 22.07.2022 KR 20220090827
(71) Applicant: LG INNOTEK CO., LTD., Seoul 07796 (KR)
(72) Inventor: NAM, Il Sik, Seoul 07796 (KR)
(74) Representative: DREISS Patentanwälte PartG mbB
(86) International application number: PCT/KR2023/010645
(87) International publication number: WO 2024/019601

(57) **Abstract**

A circuit board according to an embodiment comprises an insulating layer; a protective member disposed on the insulating layer; and a plurality of posts disposed on the insulating layer along a circumference of the protective member, wherein the protective member includes an upper surface, a lower surface, and a side surface disposed between the upper surface and the lower surface, wherein the lower surface of the protective member faces an upper surface of the insulating layer, wherein side surfaces of the plurality of posts face the side surface of the protective member, and wherein the side surface of the protective member includes a protruding portion protruding between the plurality of posts.

## Description

### [Technical Field]

An embodiment relates to a circuit board and a semiconductor package including the same.

### [Background Art]

A semiconductor package has a structure in which a semiconductor chip is attached to a circuit board. A semiconductor package can be provided by integrating multiple packages with different devices attached into one. Since multiple components are implemented in one package, such a semiconductor package has the advantage of being able to transmit high-speed signals through a short path. Accordingly, the semiconductor packages are widely used in a mobile device, etc.

Meanwhile, when attaching electronic devices such as semiconductor chips to a circuit board, the semiconductor package is performed by applying a wire. The semiconductor package with the wire structure has a problem of increasing volume. Accordingly, semiconductor packages are recently being performed by flip chip packaging. Flip chip packaging is a method of bonding and packaging semiconductor chips and circuit boards by fusing solder bumps to the connection patterns of semiconductor chips or circuit boards without using additional connecting materials such as wires when attaching electronic components such as semiconductor chips to a circuit board.

Recently, a bump pitch of an electronic device is becoming smaller due to a demand for high-speed, large-capacity data processing and the miniaturization of electronic products. Following this trend, reliability of a bump connection between the circuit board and the semiconductor chip is decreasing in flip chip packaging. In order to prevent this decrease in reliability, Korean Patent Publication No. 10-2013-0027870 proposes a structure including a post with improved reliability.

### [Disclosure]

### [Technical Problem]

The embodiment provides a circuit board having a novel structure and a semiconductor package comprising the same.

In addition, the embodiment provides a circuit board capable of reducing a spacing or pitch between a plurality of posts and a semiconductor package comprising the same.

In addition, the embodiment provides a circuit board capable of improving circuit integration and a semiconductor package comprising the same.

In addition, the embodiment provides a circuit board having improved physical and/or electrical connection reliability between posts and pads and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises an insulating layer; a protective member disposed on the insulating layer; and a plurality of posts disposed on the insulating layer along a circumference of the protective member, wherein the protective member includes an upper surface, a lower surface, and a side surface disposed between the upper surface and the lower surface, wherein the lower surface of the protective member faces an upper surface of the insulating layer, wherein side surfaces of the plurality of posts face the side surface of the protective member, and wherein the side surface of the protective member includes a protruding portion protruding between the plurality of posts.

In addition, the side surface of the protective member includes a first side surface extending in a first direction, a second side surface extending in the first direction and spaced apart from the first side surface, a third side surface extending in a second direction perpendicular to the first direction, and a fourth side surface extending in the second direction and spaced apart from the third side surface, the protruding surface of the protective member is provided on the first side surface and the third side surface.

In addition, the third side surface includes a first surface having a first separation distance with the plurality of posts along the first direction, a second surface having a second separation distance smaller than the first separation distance, and a third surface having a third separation distance greater than the first separation distance.

In addition, a separation distance along the first direction between the fourth side surface and the plurality of posts is uniform.

In addition, the second side surface of the protective member includes a concave surface concave toward the first side surface of the protective member.

In addition, the protective member includes a plurality of through holes, and a width of the plurality of through holes is smaller than a width of the post.

In addition, the circuit board further comprises an outer protective member disposed on the insulating layer and having a through hole, and the post and the protective member are disposed in the through hole of the outer protective member.

In addition, the circuit board further comprises a surface treatment layer disposed on the post.

In addition, the circuit board further comprises a plurality of pads disposed between the insulating layer and the protective member, the widths of the plurality of through holes of the protective member are smaller than widths of the plurality of pads, and the width of the post is smaller than the width of the pad.

In addition, the circuit board further comprises a surface treatment layer disposed on each of the plurality of through holes of the protective member, and the surface treatment layer disposed on each of the plurality of through holes of the protective member and the surface treatment layer disposed on the post are provided with a same material.

In addition, the protective member and the outer protective member constitute an upper protective layer provided on the upper surface of the insulating layer.

In addition, the outer protective member is provided along an edge of the upper surface of the substrate.

In addition, the protective member is provided at an inner side of the outer protective member with a separation region interposed therebetween along the horizontal direction.

In addition, the separation region between an inner side surface of the outer protective member and an outer side surface of the protective member includes a first separation region having a first width along the horizontal direction and a second separation region having a second width different from the first width.

In addition, the separation region is provided as a closed loop along the outer side surface of the protective member.

In addition, the outer side surface of the protective member includes a protruding surface protruding toward the inner side surface of the outer protective member.

In addition, the protruding surface of the protective member is provided in the second separation region, and the first width is larger than the second width.

In addition, the outer side surface of the protective member includes a concave surface concave toward the inner side of the protective member.

In addition, the concave surface of the protective member is provided in the first separation region, and the first width is larger than the second width.

In addition, the protruding surface of the protective member includes a first protruding surface that protrudes toward the inner side surface of the outer protective member with a first protrusion width, and a second protruding surface that protrudes toward the inner side surface of the outer protective member with a second protrusion width larger than the first protrusion width.

In addition, the inner side surface of the outer protective member includes a first inner side surface, a second inner side surface facing the first inner side surface, and a third inner side surface and a fourth inner side surface disposed between the first inner side surface and the second inner side surface and facing each other, and the outer side surface of the protective member includes a first outer side surface adjacent to the first inner side surface, a second outer side surface adjacent to the second inner side surface, a third outer side surface adjacent to the third inner side surface, and a fourth outer side surface adjacent to the fourth inner side surface, and a separation region between the first inner side surface of the outer protective member and the first outer side surface of the protective member includes the first and second separation regions.

In addition, a spacing between a plurality of pads provided between the insulating layer and the post is smaller than a width of each of the plurality of pads.

### [Advantageous Effects]

A circuit board according to an embodiment includes an insulating layer and a protective layer disposed on the insulating layer. At this time, the protective layer may be referred to as a protective member provided in a portion of a region of an upper surface of the insulating layer. At this time, the circuit board includes a plurality of posts disposed along a circumference of the protective member on the insulating layer. In addition, the protective member includes an upper surface, a lower surface, and a side surface disposed between the upper surface and the lower surface, and the lower surface of the protective member faces the upper surface of the insulating layer, the side surfaces of the plurality of posts faces the side surfaces of the protective member, and the side surface of the protective member includes a protruding portion protruding between the plurality of posts.

For example, an outer side surface of the protective member may have a step in a horizontal direction along a circumference. Specifically, the protective member may include a protruding surface or a concave surface protruding toward the post. In addition, the protruding surface and the concave surface may be designed based on positions of the posts. For example, the protruding surface may protrude toward a region between a plurality of pads. Through this, the embodiment can improve the design freedom for arranging the pads. Accordingly, the embodiment can improve the integration of pads and posts.

In addition, the outer side surface of the protective member of the embodiment may be located inside the insulating layer by a certain distance more than the outer side surface of the insulating layer. Through this, the embodiment can improve warpage characteristics of the circuit board by using the protruding surface of the outer side surface of the protective member. That is, the protective member can be an uppermost insulating layer provided in the circuit board. In addition, a process of forming the protective member includes processes of exposure, development, and curing. In addition, stress is applied to the circuit board in the processes of exposing, developing, and curing the protective member, and accordingly, a side end of the circuit board can be bent in an upward or downward direction. At this time, the embodiment may allow the outer side surface of the protective member to be positioned further inward than the outer side surface of the insulating layer, and thus, the stress caused by expansion and/or contraction due to a heat cycle can be minimized. Therefore, the embodiment can improve the warpage characteristics of the circuit board and the semiconductor package including the same, and further improve the product reliability. In addition, the embodiment can minimize the stress acting on interfaces between each component of the circuit board, including an interface between the insulating layer and the protective member, an interface between the pad and the protective member, etc., and can stably protect the circuit board and the semiconductor package from issues such as cracks due to the stress.

In addition, the circuit board further includes an outer protective member provided at an outer side of the protective member. At this time, the outer protective member is provided along an edge of the upper surface of the insulating layer, and the protective member is provided at an inner side of the outer protective member with a separation region therebetween. At this time, the separation region between the inner side surface of the outer protective member and the outer side surface of the protective member includes a first separation region having a first width along the horizontal direction and a second separation region having a second width different from the first width.

Through this, the embodiment includes the first separation region and the second region with different widths along the circumference of the inner side surface of the outer protective member and the outer side surface of the protective member in the first and second separation regions, thereby allowing each separation region to have different circuit integrations. For example, the first width may be larger than the second width. Accordingly, pads with relatively high integration are provided in the protective member adjacent to the first separation region having the first width, and pads with relatively low integration are provided in the protective member adjacent to the second separation region having the second width. Through this, the embodiment can provide the protective member and the outer protective member including the first and second separation regions through an arrangement design of the pads, thereby improving the electrical reliability and/or mechanical reliability of the semiconductor package. Furthermore, the embodiment can reduce a signal transmission distance through the control of the circuit integration, and can improve signal transmission characteristics by minimizing the signal transmission loss accordingly.

In addition, a plurality of first pads are disposed in the separation region between the protective member and the outer protective member. At this time, the first pads do not contact the protective layer (protective member and outer protective member). For example, the plurality of first pads do not contact each of the protective member and the outer protective member. Through this, the embodiment can solve a problem of the limitation of a size of a SRO (Solder Resister Open) that can be formed in the protective layer in the separation region. Therefore, the embodiment can reduce a width of the first pads disposed in the separation region. Furthermore, the embodiment can improve the circuit integration of the first pads in the separation region.

Furthermore, the embodiment has a structure in which the protective layer is not disposed between the plurality of first pads in the separation region. Accordingly, a spacing between adjacent first pads can be reduced. Furthermore, the embodiment may allow the spacing between adjacent first pads to be smaller than the width of the first pads. Through this, the embodiment can increase a density of the first pads in the separation region. Therefore, the embodiment can reduce an area of the circuit board and the semiconductor package including the same.

In addition, a post is disposed on the first pad. At this time, a seed layer of the post is not disposed between the post and the pad. Specifically, the post of the embodiment is in direct contact with the first pad. More specifically, the post is electroplated using a seed layer used for electroplating the first pad. Therefore, the embodiment has a structure in which a chemical copper plating layer is not disposed between the first pad and the post. Therefore, the embodiment can improve physical connectivity and electrical connectivity between the first pad and the post since the first pad and the post are electroplated through a same seed layer. This is because contact properties between electrolytic coppers are better than those between chemical plating and electrolytic plating. Furthermore, the embodiment can solve the signal transmission loss caused by the chemical copper plating layer, and thus can improve the signal transmission characteristics.

In addition, the embodiment can solve a problem of undercut at a lower end of the post caused by etching the chemical copper plating layer. Through this, the embodiment can allow the upper surface and the lower surface of the post to have substantially a same width. Therefore, the embodiment can solve a dendrite problem caused by electromigration due to the difference in width between the upper surface and the lower surface of the post, thereby further improving the electrical characteristics and/or physical characteristics of the post.

In addition, the embodiment can omit a process of forming a chemical copper plating layer for forming a post and a process of etching the chemical copper plating layer. Through this, the embodiment can simplify a manufacturing process of the circuit board. Accordingly, the embodiment can improve the process yield.

### [Description of Drawings]

FIG. 1 is a cross-sectional view showing a circuit board according to a comparative example.
FIG. 2 is a cross-sectional view showing a circuit board according to a first embodiment.
FIG. 3 is a plan view of a circuit board with a first protective layer and a post of FIG. 2 removed.
FIG. 4 is a plan view of a first protective layer of FIG. 2.
FIG. 5 is a plan view of a circuit board of FIG. 2.
FIG. 6 is a cross-sectional view showing a detailed layer structure of a first through electrode, a first circuit layer, and a post of FIG. 2.
FIG. 7 is a cross-sectional view showing a circuit board according to a second embodiment.
FIG. 8 is an enlarged view showing a partial region of FIG. 7.
FIG. 9 is a drawing showing a semiconductor package according to a first embodiment.
FIG. 10 is a cross-sectional view showing a circuit board according to a third embodiment.
FIG. 11 is a cross-sectional view showing a semiconductor package according to a second embodiment.
FIG. 12 is a cross-sectional view showing a circuit board according to a fourth embodiment.
FIG. 13 is a top plan view of the circuit board of FIG. 12.
FIG. 14 is an enlarged view of a partial region of a circuit board of FIG. 12.
FIGS. 15 to 28 are drawings for explaining a method for manufacturing a circuit board according to a first embodiment illustrated in FIG. 2, in order of processes.

### [Modes of the Invention]

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms may be construed the same meaning as commonly understood by one of ordinary skill in the art to which this invention belongs, and the terms such as those defined in commonly used dictionaries may be interpreted as having a meaning that is consistent with their meaning in the context of the relevant art.

Further, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

### (comparative example)

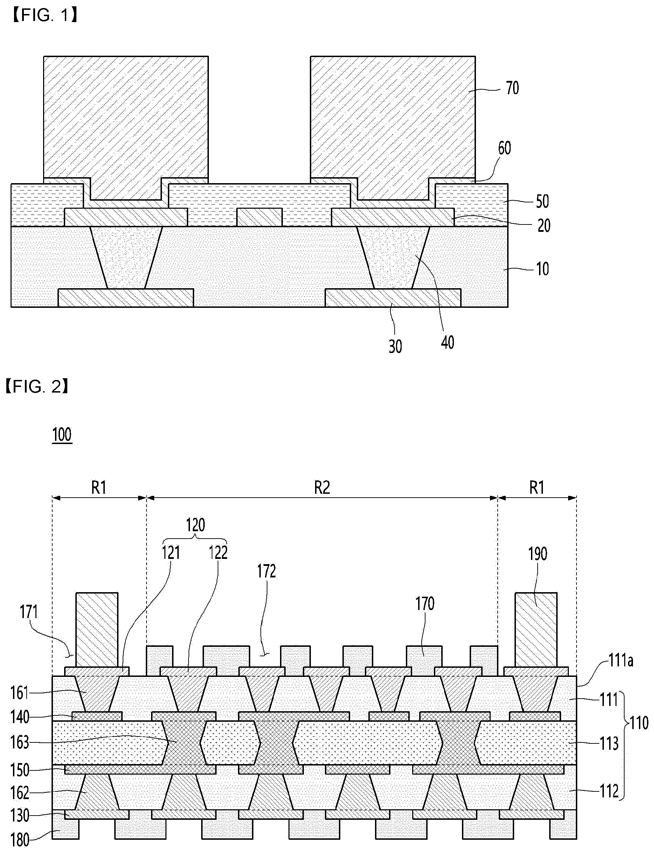

FIG. 1 is a cross-sectional view showing a circuit board according to a comparative example.

Referring to FIG. 1, the circuit board includes an insulating layer 10.

In addition, a first circuit pattern 20 is disposed on an upper surface of the insulating layer 10, and a second circuit pattern 30 is disposed on a lower surface of the insulating layer 10. The first circuit pattern 20 includes a pad. In addition, the circuit board of the comparative example includes a through electrode passing through the insulating layer 10. A protective layer 50 is disposed on an upper surface of the insulating layer 10 and having an opening that vertically overlaps with the upper surface of the pad of the first circuit pattern 20.

In addition, a post 70 is disposed on a pad of the first circuit pattern 20. The post 70 has a certain height or thickness and protrudes on the pad of the first circuit pattern 20. Therefore, the post 70 has a height or thickness of at least 80um. As a result, it is difficult to form the post 70 by electroless plating.

Accordingly, a seed layer 60 for electroplating the post 70 is disposed between the bump 70 and the pad of the first circuit pattern 20. The seed layer 60 is a chemical copper plating layer. The seed layer 60 is disposed on the upper surface of the pad of the first circuit pattern 20 and an inner wall of the protective layer 50, respectively.

That is, the comparative example has a structure in which the seed layer 60 is disposed between the post 70 and the pad of the first circuit pattern 20. Accordingly, the comparative example has a problem in that a process of forming the seed layer 60 must be additionally performed, and a manufacturing process becomes complicated or a manufacturing time increases accordingly.

In addition, the circuit board of the comparative example experiences a whitening phenomenon of the protective layer 50 by a solution used in a de-smear process of the seed layer 60 formed by electroless plating. In addition, the circuit board of the comparative example has a structure in which a seed layer 60 is disposed between the pad and the post 70, and thus the bump layer has a porous microstructure. At this time, the porous structure has a low metal density, and therefore, there is a problem in which cracks occur in the porous seed layer 60 due to external impact or other physical force. In addition, there is a problem that the post 70 is damaged due to the occurrence of the crack, and thus the product reliability or durability is drastically reduced. Furthermore, in the comparative example, there is a problem that the seed layer 60 is additionally disposed between the pad and the post 70, and thus the loss increases during signal transmission, and thus the signal transmission characteristics are reduced.

### -Electronic device-

Before describing an embodiment, an electronic device including the semiconductor package of the embodiment will be briefly described. The electronic device includes a main board (not shown). The main board may be physically and/or electrically connected to various components. For example, the main board may be electrically connected to the semiconductor package of the embodiment. Various devices may be mounted on the semiconductor package. The semiconductor package may include various devices or chips. The device or chip may include memory chips such as volatile memory (e.g., DRAM), non-volatile memory (e.g., ROM), and flash memory, application processor chips such as a central processor (e.g., CPU), graphics processor (e.g., GPU), antenna chip, digital signal processor, cryptographic processor, microprocessor, and microcontroller, and logic chips such as analog-digital converters and ASICs (application-specific ICs).

In addition, device or chip may include passive devices and active devices.

The active device refers to a component that actively utilizes a nonlinear portion of the signal characteristics. In addition, the passive device refers to a component that does not utilize the nonlinear signal characteristics even though both linear and nonlinear signal characteristics exist. For example, the active device may include a transistor, an IC semiconductor device, and the passive device may include a capacitor, a resistor, an inductor, and the like. The passive device may increase the signal processing speed of the semiconductor chip, which is the active device, or perform a filtering function. In addition, the chip may be a wireless communication chip that can be used for Wi-Fi or 5G communication.

Meanwhile, a product group to which the semiconductor package of the embodiment is applied may be any one of CSP (Chip Scale Package), FC-CSP (Flip Chip-Chip Scale Package), FC-BGA (Flip Chip Ball Grid Array), POP (Package On Package), and SIP (System In Package), but is not limited thereto.

In this case, the electronic device may be a smart phone, a personal digital assistant, a digital video camera, a digital still camera, a vehicle, a high-performance server, a network system, computer, monitor, tablet, laptop, netbook, television, video game, smart watch, automotive, or the like. However, the embodiment is not limited thereto, and may be any other electronic device that processes data in addition to these.

### - Circuit board and semiconductor package -

Hereinafter, a circuit board and a semiconductor package according to an embodiment will be described.

FIG. 2 is a cross-sectional view showing a circuit board according to a first embodiment. Hereinafter, an overall structure of the circuit board of the first embodiment will be described with reference to FIG. 2.

Referring to FIG. 2, the circuit board 100 enables at least one chip to be attached. In addition, the circuit board 100 of the embodiment can be attached to a main board of an electronic device. The main board may mean a motherboard of the electronic device. The circuit board 100 may be connected to at least one chip and a motherboard to form a first package.

In addition, the first package including the circuit board 100 of the embodiment may be coupled with a second package. The second package may be a memory package. In one embodiment, the circuit board 100 may be coupled with a memory substrate of the second package. In another embodiment, the circuit board may be coupled with an interposer coupled to the memory substrate.

The circuit board 100 includes an insulating layer 110. The insulating layer 110 may include a plurality of layers. In one embodiment, the insulating layer 110 may have a three-layer structure, but is not limited thereto. At this time, the insulating layer 110 may be referred to as a supporting substrate that supports the circuit board 100, and thus may be referred to as a 'substrate'.

In one embodiment, the circuit board 100 may be a core substrate. For example, the circuit board 100 may include a core layer. For example, the insulating layer 110 of the circuit board 100 of the embodiment may include a third insulating layer 113 corresponding to the core layer including reinforcing fibers.

The circuit board 100 may have a structure in which at least one insulating layer is laminated on each of upper and lower portions with the third insulating layer 113 interposed therebetween. In one embodiment, an insulating layer laminated on an upper side and an insulating layer laminated on a lower side of the third insulating layer 113 may have a symmetrical structure. In another embodiment, an insulating layer laminated on an upper side and an insulating layer laminated on a lower side of the third insulating layer 113 may have an asymmetrical structure.

Hereinafter, the circuit board 100 of the embodiment is described as a core substrate, and accordingly, the third insulating layer 113 is a core layer. However, the embodiment is not limited thereto. For example, the circuit board 100 of another embodiment may be a coreless substrate that does not include a core layer.

Meanwhile, structural features of the circuit board of the embodiment are in an opening of a protective layer and an outermost circuit layer and a post disposed in the opening of the protective layer. In addition, the protective layer, circuit layer, and post described below may be applied to a coreless substrate. Furthermore, at least one of the circuit layers of the outermost layer of the embodiment may have an ETS (Embedded Trace Substrate) structure embedded in a surface of the insulating layer 110.

The insulating layer (or substrate) 110 of the circuit board 100 of the embodiment may include a first insulating layer 111, a second insulating layer 112, and a third insulating layer 113.

The third insulating layer 113 may refer to an inner insulating layer disposed at an inner side among a plurality of insulating layers. The third insulating layer 113 may be disposed between the first insulating layer 111 and the second insulating layer 112. The third insulating layer 113 may include a prepreg. The third insulating layer 113 may include reinforcing fibers.

The first insulating layer 111 may be disposed on the third insulating layer 113. For example, the first insulating layer 111 may be disposed on an upper surface of the third insulating layer 113. The first insulating layer 111 may refer to a first outermost insulating layer among the insulating layer 110 of the circuit board 100. For example, the first insulating layer 111 may refer to an insulating layer disposed at an uppermost side among the insulating layer 110 of the circuit board 100. The first insulating layer 111 may provide a mounting region in which at least one chip is mounted, or a first bonding region in which a first external substrate is coupled. The first external substrate may be a main board of an electronic device.

The second insulating layer 112 may be disposed under the third insulating layer 113. The second insulating layer 112 may refer to a second outermost insulating layer among the insulating layer 110 of the circuit board 100. For example, the second insulating layer 112 may refer to an insulating layer disposed at a lowermost side of the insulating layer 110 of the circuit board 100. The second insulating layer 112 may provide a mounting region in which at least one chip is mounted, or a second bonding region in which a second external substrate is bonded. The second external substrate may be a memory substrate or an interposer.

The first insulating layer 111 and the second insulating layer 112 may be rigid or flexible. For example, the first insulating layer 111 and the second insulating layer 112 may include glass or plastic. In detail, the first insulating layer 111 and the second insulating layer 112 may include chemically strengthened/semi-strengthened glass such as soda lime glass or aluminosilicate glass. Alternatively, the first insulating layer 111 and the second insulating layer 112 may include a reinforced or flexible plastic such as polyimide (PI), polyethylene terephthalate (PET), propylene glycol (PPG), or polycarbonate (PC). Alternatively, the first insulating layer 111 and the second insulating layer 112 may include sapphire.

In addition, the first insulating layer 111 and the second insulating layer 112 may include an optically isotropic film. For example, the first insulating layer 111 and the second insulating layer 112 may include COC (Cyclic Olefin Copolymer), COP (Cyclic Olefin Polymer), optically isotropic polycarbonate (PC), or optically isotropic polymethyl methacrylate (PMMA).

In addition, the first insulating layer 111 and the second insulating layer 112 may be formed of a material including an inorganic filler and an insulating resin. For example, the first insulating layer 111 and the second insulating layer 112 may include a structure in which an inorganic filler such as silica or alumina is dispersed in a thermosetting resin such as an epoxy resin or a thermoplastic resin such as a polyimide. For example, the first insulating layer 111 and the second insulating layer 112 may include ABF (Ajinomoto Build-up Film), FR-4, BT (Bismaleimide Triazine), PID (Photo Imageable Dielectric resin), BT, etc.

Each of the first insulating layer 111 and the second insulating layer 112 may have a thickness in a range of 10 µm to 60 µm. Preferably, each of the first insulating layer 111 and the second insulating layer 112 may have a thickness in a range of 12 µm to 50 µm. More preferably, each of the first insulating layer 111 and the second insulating layer 112 may have a thickness in a range of 15 µm to 40 µm.

If the thickness of the first insulating layer 111 or the second insulating layer 112 is less than 10 µm, the circuit layer included in the circuit board 100 may not be stably protected. In addition, if the thickness of the first insulating layer 111 or the second insulating layer 112 exceeds 60 µm, a thickness of the circuit board 100 may increase, and thereby a thickness of the semiconductor package may increase. In addition, if the thickness of the first insulating layer 111 or the second insulating layer 112 exceeds 60 µm, a thickness of the circuit layer and a thickness of the through electrode may increase accordingly. In addition, if the thickness of the circuit layer and the thickness of the through electrode increase, it may be difficult to implement miniaturization, which may decrease the circuit integration. Furthermore, a signal transmission distance may increase, which may increase signal transmission loss.

Meanwhile, the first insulating layer 111 may be divided into a plurality of regions in a direction.

The first insulating layer 111 may include a first region R1 adjacent to a circumference 111a of the first insulating layer 111. The circumference 111a of the first insulating layer 111 may mean a circumference of an upper surface of the first insulating layer 111. The circumference 111a of the first insulating layer 111 may mean an edge of the upper surface of the first insulating layer 111 adjacent to a side surface of the first insulating layer 111. The first insulating layer 111 may include a second region R2 other than the first region R1. The circumference 111a of the first insulating layer 111 may mean an outermost part of the upper surface of the first insulating layer 111 that is most adjacent to the side surface of the first insulating layer 111. At this time, the first region R1 may be a region corresponding to the first opening of the protective layer to be described later, and may further correspond to a separation region between an outer protective member and a protective member in another embodiment.

The second region R2 may mean a region that is further away from the circumference 111a of the first insulating layer 111 than the first region R1.

At this time, the first region R1 of the first insulating layer 111 may be formed along a circumferential direction of the first insulating layer 111. In addition, the second region R2 of the first insulating layer 111 may mean an inner region of the first region R1 formed along the circumferential direction. For example, the first region R1 of the first insulating layer 111 may mean an outer region of the upper surface of the first insulating layer 111, and the second region R2 may mean an inner region of the upper surface of the first insulating layer 111 excluding the first region R1.

Meanwhile, the first region R1 and the second region R2 have been described as the first region R1 and the second region R2 of the first insulating layer 111, but are not limited thereto. For example, the first region R1 and the second region R2 may refer to a first region R1 and a second region R2 of the circuit board 100.

The circuit board 100 of the embodiment includes a circuit layer disposed on a surface of the insulating layer 110.

For example, the circuit board 100 may include a first circuit layer 120 disposed on an upper surface of the first insulating layer 111. For example, the circuit board 100 may include a second circuit layer 130 disposed on a lower surface of the second insulating layer 112. In addition, the circuit board 100 may include a third circuit layer 140 disposed between the lower surface of the first insulating layer 111 and the upper surface of the third insulating layer 113. For example, the circuit board 100 may include a fourth circuit layer 150 disposed between the upper surface of the second insulating layer 112 and the lower surface of the third insulating layer 113.

The first circuit layer 120, the second circuit layer 130, the third circuit layer 140, and the fourth circuit layer 150 may be manufactured using a conventional printed circuit board manufacturing process such as an additive process, a subtractive process, a modified semi-additive process (MSAP), and a semi-additive process (SAP), and a detailed description thereof is omitted herein.

The first circuit layer 120 may refer to a circuit layer disposed on a first outermost layer of the circuit board 100. In addition, the second circuit layer 130 may refer to a circuit layer disposed on a second outermost layer of the circuit board 100.

The first circuit layer 120 may include a plurality of pads disposed on the first insulating layer 111.

The first circuit layer 120 may include a first pad 121 disposed in the first region R1 of the first insulating layer 111. In addition, the first circuit layer 120 may include a second pad 122 disposed in the second region R2 of the first insulating layer 111. The second pad 122 may be spaced further from the circumference 111a of the first insulating layer 111 than the first pad 121.

The first pad 121 may perform a first function, and the second pad 122 may perform a second function different from the first function.

The first function of the first pad 121 may mean a function for bonding a first external substrate to the circuit board 100. In addition, the second function of the second pad 122 may mean a function for mounting a chip on the circuit board 100.

Meanwhile, the first circuit layer 120 may further include a trace. The trace of the first circuit layer 120 may be disposed in the first region R1 and the second region R2 of the first insulating layer 111. The trace of the first circuit layer 120 may connect between a plurality of first pads, between a plurality of second pads, or between the first pad 121 and the second pad 122.

A planar area of the first pad 121 may be different from a planar area of the second pad 122. For example, a diameter of the first pad 121 in a first horizontal direction may be different from a diameter of the second pad 122 in a first horizontal direction. For example, a width of the first pad 121 may be different from a width of the second pad 122.

That is, the first pad 121 is a pad for bonding with the first external substrate, and the second pad 122 is a pad for mounting the chip. In addition, due to reasons such as 5G, the Internet of Things (IOT), increased image quality, and increased communication speed, a number of terminals of the chip is increasing, or a width or a pitch of the terminals of the chip is becoming smaller. In contrast, pads provided on the first external substrate may have a larger width or spacing than the terminals of the chip. Therefore, the planar area, the diameter or width in the first horizontal direction of the first pad 121 may be larger than the planar area, the diameter or width in the first horizontal direction of the second pad 122.

The first pad 121 may not be in contact with the protective layer of the circuit board 100 while being disposed in the first region R1. For example, the side surface and the upper surface of the first pad 121 may not be in contact with the protective layer. This will be described in more detail below.

In contrast, the second pad 122 may be in contact with the protective layer of the circuit board 100 while being disposed in the second region R2. For example, at least a portion of the side surface and the upper surface of the second pad 122 may be in contact with the protective layer.

Meanwhile, the second circuit layer 130 may also include a plurality of pads. The pads of the second circuit layer 130 of the circuit board 100 of the first embodiment may include only pads for mounting a chip, but are not limited thereto.

Meanwhile, the first circuit layer 120, the second circuit layer 130, the third circuit layer 140, and the fourth circuit layer 150 may be formed of at least one metal material selected from gold (Au), silver (Ag), platinum (Pt), titanium (Ti), tin (Sn), copper (Cu), and zinc (Zn). In addition, the first circuit layer 120, the second circuit layer 130, the third circuit layer 140, and the fourth circuit layer 150 may be formed of a paste or solder paste including at least one metal material selected from gold (Au), silver (Ag), platinum (Pt), titanium (Ti), tin (Sn), copper (Cu), and zinc (Zn) having excellent bonding strength. Preferably, the first circuit layer 120, the second circuit layer 130, the third circuit layer 140, and the fourth circuit layer 150 may be formed of copper (Cu) which is relatively inexpensive.

Meanwhile, the first circuit layer 120 and the second circuit layer 130 may have a thickness in a range of 5 µm to 30 µm. For example, the first circuit layer 120 and the second circuit layer 130 may have a thickness in a range of 6 µm to 25 µm. The first circuit layer 120 and the second circuit layer 130 may have a thickness in a range of 7 µm to 20 µm. If the thickness of the first circuit layer 120 and the second circuit layer 130 is less than 5 µm, resistance may increase and signal transmission loss may increase. If the thickness of the first circuit layer 120 and the second circuit layer 130 exceeds 30µm, miniaturization is difficult, and the circuit integration may decrease accordingly.

The circuit board 100 of the embodiment may include a post 190.

The post 190 may be disposed on the first circuit layer 120. Preferably, the post 190 may be disposed on the first pad 121 of the first circuit layer 120.

The post 190 may have a diameter or width smaller than the diameter or width of the first pad 121. Accordingly, a part of the first pad 121 may vertically overlap with the post 190, and a remaining part of the first pad 121 may not vertically overlap with the post 190.

The post 190 may not be in contact with the first protective layer 170 described below. For example, the post 190 may be disposed in a first opening 171 of a first protective layer 170. Correspondingly, the first pad 121 of the first circuit layer 120 may also be disposed in a first opening 171 of the first protective layer 170. At this time, the first protective layer 170 in the first embodiment may have a structure including only a "protective member" in another embodiment described below. Accordingly, the first opening 170 of the first protective layer 170 may correspond to a separation region between an "outer protective member" and a protective member described below.

The post 190 may be disposed with a certain height on the first pad 121. The height may refer to a vertical distance from an upper surface of the post 190 to a lower surface of the post 190. The height of the post 190 may be greater than 100 µm, greater than 120 µm, greater than 140 µm, greater than 160 µm, or greater than 200 µm.

For example, a height of the post 190 may satisfy a range of 100 µm to 220 µm. Preferably, the height of the post 190 may satisfy a range of 110 µm to 215 µm. More preferably, the height of the post 190 may satisfy a range of 115 µm to 210 µm.

If the height of the post 190 is less than 100 µm, the first external substrate may not be stably bonded to the post 190. If the height of the post 190 is less than 100 µm, a distance between the first external substrate and the circuit board 100 decreases, and thus, signal transmission characteristics may deteriorate due to signal interference between them. In addition, if the height of the post 190 exceeds 220 µm, the rigidity of the post 190 may decrease. In addition, if the rigidity of the post 190 decreases, a physical reliability problem such as collapse may occur during a bonding process with the first external substrate. If the height of the post 190 exceeds 220 µm, a thickness of the circuit board 100 and a thickness of the semiconductor package may increase.

The circuit board 100 of the embodiment may include a through electrode. The through electrode may penetrate the insulating layer 110.

For example, the circuit board 100 may include a first through electrode 161 penetrating the first insulating layer 111. In addition, the circuit board 100 may include a second through electrode 162 penetrating the second insulating layer 112. In addition, the circuit board 100 may include a third through electrode 163 penetrating the third insulating layer 113.

The first through electrode 161, the second through electrode 162, and the third through electrode 163 may be disposed in a through hole penetrating at least one insulating layer. For example, the first through electrode 161, the second through electrode 162, and the third through electrode 163 may be formed by filling the through hole with a conductive material.

The through hole may be formed by any one of mechanical, laser, and chemical processing methods. The through hole may be formed by a mechanical processing method such as milling, drilling, and routing. In addition, the through hole may use a UV or CO₂ laser method. In addition, the first through hole may use a chemical processing method using a chemical agent including amino silane, ketones, etc.

Meanwhile, the first through electrode 161 may be formed in multiple numbers while being spaced apart in the horizontal direction within the first insulating layer 111.

At this time, the first through electrode 161 may overlap the first circuit layer 120 in a vertical direction.

The first through electrode 161 may be vertically overlapped with at least one of the first pad 121 and the second pad 122. For example, the first through electrode 161 may include a first electrode part vertically overlapping the first pad 121 and a second electrode part vertically overlapping the second pad 122. In addition, the first electrode part and the second electrode part of the first through electrode 161 may have different widths. At this time, each of the first electrode part and the second electrode part of the first through electrode 161 may have a slope whose width decreases from an upper surface to a lower surface. In addition, the upper surface of the first electrode part of the first through electrode 161 may have a larger width than the upper surface of the second electrode part of the first through electrode 161. That is, the first electrode part of the first through electrode 161 is connected to the first pad 121 having a relatively larger width than the second pad 122 connected to the second electrode part of the first through electrode 161. Accordingly, the first electrode part of the first through electrode 161 can have a larger width than the second electrode part.

Through this, the embodiment allows a plurality of electrode parts disposed in a same layer and horizontally spaced from each other to have different widths, thereby improving the circuit integration. Specifically, the second electrode part of the first through electrode 161 is connected to the second pad 122 connected to the chip. In addition, the second electrode part has a relatively small width, thereby reducing the width and pitch of the second pad 122. The embodiment can improve the circuit integration in the second region R2 where the second pad 122 is disposed. Furthermore, the first electrode part of the embodiment has a relatively large width. Accordingly, the embodiment can improve heat transfer characteristics generated in the circuit board 100 through the first electrode part. Through this, the embodiment can improve the heat dissipation characteristics of the circuit board 100 and the semiconductor package comprising the same.

Meanwhile, the circuit board 100 of the embodiment includes a protective layer.

Specifically, a first protective layer 170 is disposed on the upper surface of the first insulating layer 111. The first protective layer 170 includes an opening. The opening can be defined as a 'through hole' penetrating the upper surface and the lower surface of the first protective layer 170. In addition, the opening 171 can also be defined as an 'undisposed region' or 'open region' where the first protective layer 170 is not disposed on the upper surface of the first insulating layer 111 and/or the upper surface of the first circuit layer 120. In addition, the opening of the first protective layer 170 may be defined as a separation region. At this time, the first protective layer 170 of the first embodiment has a structure that includes only a protective member of the protective layer of another embodiment, and accordingly, a separation region may mean a separation region between an outer side of the insulating layer and an outer side of the first protective layer 170. For example, the first protective layer 170 of the first embodiment may be referred to as a 'protective member'.

In addition, the upper surface of the first insulating layer 111 and/or the upper surface of the first circuit layer 120 in a region that vertically overlaps the opening of the first protective layer 170 may be exposed to an upper side of the circuit board 100.

The first protective layer 170 may include a first opening 171 and a second opening 172.

The first opening 171 of the first protective layer 170 may be provided in the first region R1. In addition, the second opening 172 of the first protective layer 170 may be provided in the second region R2 of the first protective layer 170. A number of the first openings 171 and a number of the second openings 172 may be different. The number of the first openings 171 may be one. For example, the first protective layer 170 may include one first opening 171 that vertically overlaps with a plurality of first pads 121. In addition, the first opening 171 may also vertically overlap with a post 190 disposed on the first pad 121. Meanwhile, the number of the second openings 172 may be multiple. For example, the first protective layer 170 may include a plurality of second openings 172 that vertically overlap with each of the plurality of second pads 122.

At this time, the first opening 171 of the first protective layer 170 may vertically overlap with the first region R1 as a whole. That is, the first opening 171 of the first protective layer 170 may entirely open the upper surface of the first insulating layer 111 and the upper surface and side surface of the first circuit layer 120 in the first region R1. Accordingly, the first opening 171 may substantially mean an undisposed region where the first protective layer 170 is not disposed on the first insulating layer 111 and the first circuit layer 120. In addition, the first opening 171 may not be connected to the plurality of second openings 172.

The second opening 172 of the first protective layer 170 may partially vertically overlap with the second region R2. That is, the second opening 172 of the first protective layer 170 may partially vertically overlap with the upper surface of the first insulating layer 111 and the upper surface of the first circuit layer 120 in the second region R2.

For example, the first region R1 may include a first sub-region that vertically overlaps with the plurality of first pads. In addition, the first protective layer 170 does not vertically overlap with the first sub-region. For example, the first opening 171 of the first protective layer 170 vertically overlaps with the first sub-region. In addition, the first region R1 may include a second sub-region corresponding to a region between a plurality of adjacent first pads. In addition, the first protective layer 170 does not vertically overlap with the second sub-region. In other words, the first opening 171 of the first protective layer 170 vertically overlaps with the second sub-region.

Therefore, the first opening 171 of the first protective layer 170 of the embodiment may vertically overlap with the first region R1 as a whole, and the second opening 172 may partially vertically overlap with the second region R2.

Meanwhile, the circuit board 100 may further include a second protective layer 180 disposed on the lower surface of the second insulating layer 112.

The second protective layer 180 may include at least one opening. For example, the second protective layer 180 may include an opening that vertically overlaps at least a portion of the second circuit layer 130. The opening of the second protective layer 180 may entirely or partially vertically overlap a pad connected to a chip among the second circuit layers 130.

The first protective layer 170 and the second protective layer 180 may include an insulating material. The first protective layer 170 and the second protective layer 180 may include various materials that can be applied and then cured by heating to protect the surfaces of the insulating layer and the circuit layer.

The first protective layer 170 and the second protective layer 180 may be a solder resist layer including an organic polymer material. For example, the first protective layer 170 and the second protective layer 180 may include an epoxy acrylate series resin. In detail, the first protective layer 170 and the second protective layer 180 may include a resin, a curing agent, a photoinitiator, a pigment, a solvent, a filler, an additive, an acrylic monomer, etc. However, the embodiment is not limited thereto, and the first protective layer 170 and the second protective layer 180 may be any one of a photo solder resist layer, a cover-lay, and a polymer material.

A thickness of the first protective layer 170 and the second protective layer 180 may be 1 µm to 20 µm. The thickness of the first protective layer 170 and the second protective layer 180 may be 1 µm to 15 µm. For example, the thickness of the first protective layer 170 and the second protective layer 180 may be 5 µm to 20 µm. If the thickness of the first protective layer 170 and the second protective layer 180 exceeds 20 µm, the overall thickness of the circuit board and semiconductor package may increase.

Hereinafter, a partial configuration of the circuit board 100 illustrated in FIG. 2 will be described in detail.

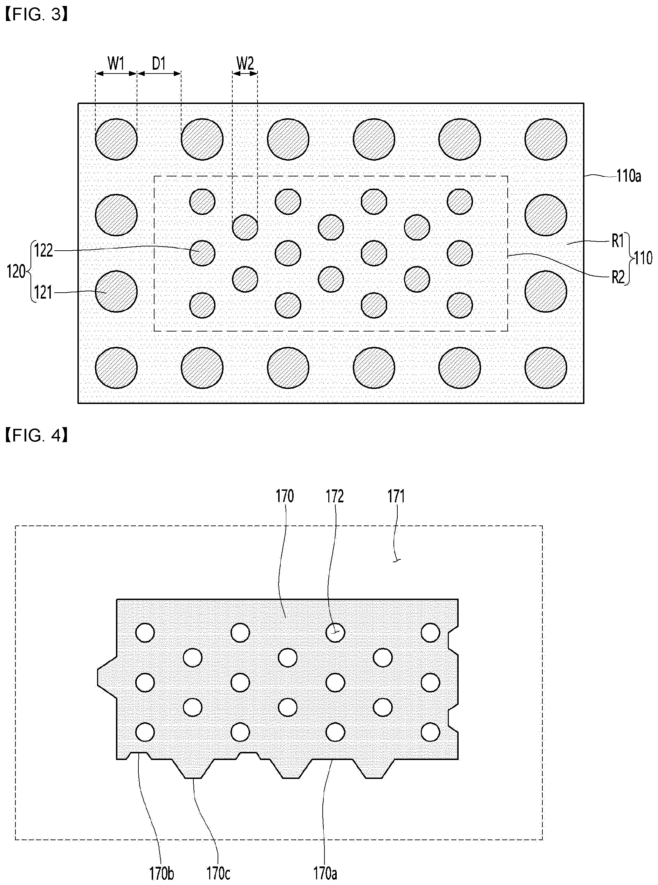

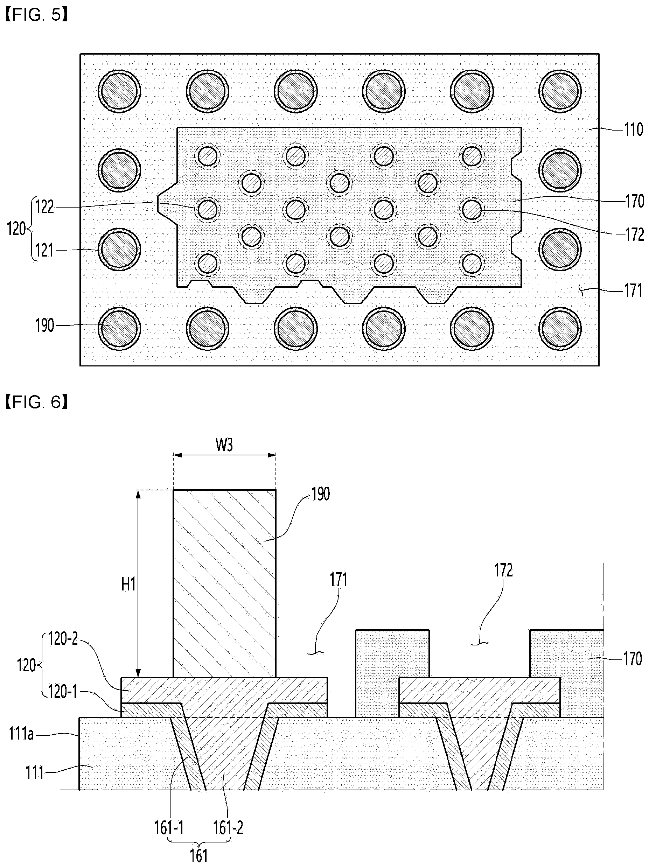

FIG. 3 is a plan view of a circuit board with a first protective layer and a post of FIG. 2 removed, FIG. 4 is a plan view of a first protective layer of FIG. 2, FIG. 5 is a plan view of a circuit board of FIG. 2, and FIG. 6 is a cross-sectional view showing a detailed layer structure of a first through electrode, a first circuit layer, and a post of FIG. 2.

Referring to FIG. 3, the first insulating layer 111 may include a first region R1 and a second region R2. The first region R1 of the first insulating layer 111 may be a region adjacent to the circumference 111a of the first insulating layer 111. For example, the first region R1 of the first insulating layer 111 may be an outer region of the upper surface of the first insulating layer 111.

The first region R1 may be adjacent to the circumference 111a of the first insulating layer 111 and may be provided in the circumferential direction of the first insulating layer 111. For example, the first region R1 may be adjacent to the circumference 111a of the first insulating layer 111 and may have a closed loop shape corresponding to the circumference 111a. However, the embodiment is not limited thereto. The first region R1 may have an open loop shape including only some regions of the circumferential region of the circumferential direction.

A plurality of first pads 121 may be disposed in the first region R1 of the first insulating layer 111. The plurality of first pads 121 may be disposed along the circumferential direction of the first insulating layer 111 in the first region R1 of the first insulating layer 111.

In addition, a plurality of second pads 122 may be disposed in the second region R2 of the first insulating layer 111. The plurality of second pads 122 may be selectively disposed in the second region R2 of the first insulating layer 111 while being spaced apart from the first pad 121 in the horizontal direction.

Meanwhile, although not shown in FIG. 3, a trace of the first circuit layer 120 may be disposed in the second region R2 of the first insulating layer 111. The trace of the first circuit layer 120 may electrically connect between the plurality of second pads disposed in the second region R2.

Furthermore, the trace of the first circuit layer 120 may not be disposed in the first region R1 of the first insulating layer 111. Specifically, only a plurality of first pads 121 may be disposed in the first region R1 of the first insulating layer 111. In addition, the first pads 121 may be electrically connected to other circuit layers of the circuit board 100 through the first through electrode 161. However, the embodiment is not limited thereto. For example, the trace of the first circuit layer 120 may also be disposed in the first region R1.

The first pad 121 may have a first width W1. In addition, the second pad 122 may have a second width W2. At this time, the first width W1 may be different from the second width W2.

Specifically, the first width W1 may correspond to a pad provided in a first external substrate (preferably, a main board of an electronic device) coupled to the circuit board 100. In addition, the second width W2 may correspond to the width of the terminal provided in the chip.

At this time, the pad provided in the first external substrate has a relatively larger width than the width of the terminal of the chip. Accordingly, the first width W1 of the first pad 121 may be larger than the second width W2 of the second pad 122.

The first width W1 of the first pad 121 may be 25 µm to 85 µm. Preferably, the first width W1 of the first pad 121 may be 30 µm to 80 µm. More preferably, the first width W1 of the first pad 121 may be 32 µm to 75 µm.

If the first width W1 of the first pad 121 is less than 25 µm, the bonding property with the first external substrate may be reduced. If the first width W1 of the first pad 121 is less than 25 µm, a width W3 of the post 190 disposed on the first pad 121 may decrease accordingly. In addition, if the width W3 of the post 190 decreases, a height H1 of the post 190 that can be formed may decrease accordingly. In addition, if the first width W1 of the first pad 121 is less than 25 µm, the heat dissipation characteristics of the circuit board 100 may deteriorate.

If the first width W1 of the first pad 121 exceeds 85 µm, a number of first pads 121 that can be disposed in the first region R1 may decrease. For example, if the first width W1 of the first pad 121 exceeds 85 µm, the circuit integration in the first region R1 may be reduced. Accordingly, an area of the circuit board 100 may increase in order to place all of the first pads connected to the first external substrate in the first region R1.

Meanwhile, the first pad 121 may have a circular planar shape. In addition, when the planar shape of the first pad 121 is circular, the first width W1 may mean a diameter of the first pad 121.

In another embodiment, the planar shape of the first pad 121 may be a square or a rectangle. In addition, when the planar shape of the first pad 121 is a square or a rectangle, the first width W1 of the first pad 121 may mean a smaller width among a width in a width direction and a width in a length direction of the first pad 121.

In another embodiment, the planar shape of the first pad 121 may be an ellipse. In addition, when the planar shape of the first pad 121 is an ellipse, the first width W1 of the first pad 121 may mean a diameter in a short axis direction of the ellipse.

Meanwhile, the plurality of first pads in the first region R1 may be spaced apart by a first spacing D1. The first spacing D1 may mean a minimum spacing between two first pads that are adjacently disposed among the plurality of first pads disposed in the first region R1.

In one embodiment, the first spacing D1 may have a range corresponding to the first width W1 of one first pad 121.

In another embodiment, the first spacing D1 may be smaller than the first width W1 of one first pad 121.

For example, the first spacing D1 between the plurality of first pads can satisfy a range of 20% to 90% of the first width W1 of the first pad 121. Preferably, the first spacing D1 between the plurality of first pads can satisfy a range of 23% to 88% of the first width W1 of the first pad 121. More preferably, the first spacing D1 between the plurality of first pads can satisfy a range of 25% to 85% of the first width W1 of the first pad 121.

If the first spacing D1 between the plurality of first pads is less than 20% of the first width W1 of the first pad 121, a circuit short may occur between the plurality of first pads 121 depending on the process capability in a process of manufacturing the circuit board 100, and thereby the electrical reliability of the circuit board 100 may be deteriorated. In addition, if the first spacing D1 between the plurality of first pads is less than 20% of the first width W1 of the first pad 121, interference may occur between signals transmitted through the plurality of first pads 121. In addition, if the interference occurs, signal transmission loss may increase, and thus, signal transmission characteristics may be deteriorated.

Meanwhile, if the first spacing D1 between the plurality of first pads exceeds 90% of the first width W1 of the first pad 121, a circuit integration enhancement effect in the first region R1 may be insignificant compared to the comparative example.

At this time, in the comparative example, the spacing between the plurality of first pads exceeded 95% of the first width of the first pad. This is because an opening size of the protective layer was included in one of the factors determining the spacing between the first pads. That is, the first protective layer of the comparative example includes a plurality of first openings that partially vertically overlapped the first region. Specifically, the first openings of the first protective layer of the comparative example were provided corresponding to the number of the first pads. In addition, the plurality of first openings of the first protective layer of the comparative example had a structure that vertically overlapped the plurality of first pads in a 1:1 ratio. Accordingly, in the comparative example, the first width of the plurality of first pads and the first spacing between the plurality of first pads were determined in consideration of the process capability and process error in a process of forming the plurality of first openings in the first protective layer.

In contrast, the first protective layer 170 of the circuit board of the embodiment includes a first opening 171 that opens the first region R1 as a whole. At this time, a configuration that opens the first region R1 as a whole is referred to as the first opening 171 of the first protective layer 170, but the first protective layer 170 can actually be disposed only in the second region R2 excluding the first region R1. That is, the first protective layer 170 can be selectively disposed only in the second region R2 while not being disposed in the first region R1.

Therefore, the embodiment does not have to consider the process capability and process error, etc. in a process of forming a plurality of first openings in the first protective layer 170. Accordingly, the embodiment can reduce the first width W1 of the first pad 121 and the first spacing D1 between the plurality of first pads compared to the comparative example.

However, in general, the first width W1 of the first pad 121 is determined based on a width of the pad provided in the main board corresponding to the first external substrate and the width W3 of the post 190 corresponding thereto. Therefore, in the embodiment, it is possible to reduce the first width W1 of the first pad 121, but instead of reducing the first width W1 of the first pad 121, the first spacing D1 between the plurality of first pads is reduced. Through this, the embodiment can improve the circuit integration while maintaining the width of the existing first pad 121.

Meanwhile, the second width W2 of the second pad 122 may be smaller than the first width W1 of the first pad 121.

The second width W2 of the second pad 122 may be 15 µm to 50 µm. Preferably, the second width W2 of the second pad 122 may be 18 µm to 45 µm. More preferably, the second width W2 of the second pad 122 may be 20 µm to 40 µm.

If the second width W2 of the second pad 122 is less than 15 µm, a resistance of a signal transmitted through the second pad 122 may increase, thereby increasing the signal transmission loss. If the second width W2 of the second pad 122 exceeds 50 µm, the circuit integration may be reduced. In addition, if the circuit integration is reduced, it may not be possible to place all the second pads connected to the terminals of the chip within a limited space. In addition, if the second width W2 of the second pad 122 exceeds 50 µm, a spacing between the plurality of second pads connected to the terminals of the chip may also increase. At this time, the second pads include at least two second pads connected to each other. In addition, if the spacing increases, a signal transmission distance between the at least two second pads increases, and thus the signal transmission loss may increase. As a result, the signal transmission characteristics may deteriorate.

Meanwhile, referring to FIG. 4, the first protective layer 170 is partially disposed on the first insulating layer 111. Specifically, the first protective layer 170 is disposed in the second region R2 of the first insulating layer 111. That is, the first protective layer 170 is not disposed in the first region R1 of the first insulating layer 111.

In other words, the first protective layer 170 may be selectively disposed only in the second region R2 while including a first opening 171 that opens the first region R1 as a whole. Accordingly, the first opening 171 may be referred to as an open region or an undisposed region of the first protective layer 170. In addition, the first protective layer 170 is not disposed in a region between the plurality of first pads. That is, the first protective layer 170 opens the first region R1 as a whole. Accordingly, a structure may be formed in which the first protective layer 170 is not disposed between the plurality of first pads.

In addition, the first protective layer 170 may include a second opening 172 that vertically overlaps the second pad 122 disposed in the second region R2.

At this time, a planar area of the first opening 171 of the first protective layer 170 may be different from a planar area of the second opening 172 of the first protective layer 170. Preferably, the planar area of the first opening 171 of the first protective layer 170 may be larger than the planar area of the second opening 172. At this time, the second opening 172 may be provided in multiple numbers in the first protective layer 170 that vertically overlaps the second region R2. At this time, being provided in multiple numbers may mean that the plurality of openings are not connected to each other but are spaced apart in the horizontal direction.

In addition, the first opening 171 is configured in one number. Here, a fact that the first opening 171 is composed of one may mean that the first protective layer 170 does not exist in a region that vertically overlaps the first region R1.

Accordingly, an outer side surface of the first protective layer 170 may be located inside the circumference 111a of the first insulating layer 111. Specifically, the outer side surface of the first protective layer 170 may be located further inside than the outer side surface of the first insulating layer 111 by the width of the first region R1.

In addition, the embodiment can improve the warpage characteristics of the circuit board by positioning the outer side surface of the first protective layer 170 further inside than the outer side surface of the first insulating layer 111. In other words, the first protective layer 170 is an outermost insulating layer of the circuit board 100. In addition, a process of forming the first protective layer 170 includes the processes of exposing, developing, and curing the first protective layer 170. In addition, in the process of exposing, developing, and curing the first protective layer 170, stress is applied to the circuit board, and accordingly, the side end of the circuit board may be bent in an upward or downward direction. At this time, the embodiment can minimize the applied stress by positioning the outer side surface of the first protective layer 170 further inside than the outer side surface of the first insulating layer 111. Accordingly, the embodiment can improve the warpage characteristics of the circuit board and the semiconductor package including the same, and further improve the product reliability.

The outer side surface of the first protective layer 170 may have a step in the horizontal direction along the circumference. Specifically, the outer side surface of the first protective layer 170 may include a first portion 170a. In addition, the outer side surface of the first protective layer 170 may include a second portion 170b corresponding to a concave surface that is concave inwardly based on the first portion 170a. In addition, the outer side surface of the first protective layer 170 may include a third portion 170c that is convex or protrudes outwardly based on the first portion 170a. Accordingly, a separation region between an outer side of the substrate and the outer side surface of the first protective layer 170 may include a first separation region having a first width and a second separation region having a second width different from the first width. The first width may be larger than the second width, and the first separation region may mean a width in the horizontal direction between the outer side of the substrate and the second portion 170b corresponding to the concave surface of the first protective layer 170. In addition, the second separation region may mean a width in the horizontal direction between the outer side of the substrate and the third portion 170c corresponding to the convex surface of the first protective layer 170.

At this time, the first portion 170a, the second portion 170b, and the third portion 170c of the first protective layer 170 may be designed based on positions of the first pads positioned adjacent to the first protective layer 170.

For example, the second portion 170b of the first protective layer 170 may overlap with the first pad adjacent to the first protective layer 170 in the length direction or width direction. In addition, the third portion 170c of the first protective layer 170 of the first protective layer 170 may overlap with a region between the plurality of first pads positioned adjacent to the first protective layer 170 in the length direction or width direction.

As described above, the embodiment can improve the design freedom for the arrangement of the first pads in the first region R1 by including the second portion 170b and the third portion 170c as well as the first portion 170a of the outer side surface of the protective layer 170. Through this, the embodiment can further improve the integration of the first pads in the first region R1.

That is, the post 190 can be provided along the circumference of the outer side surface of the first protective layer 170. At this time, the first protective layer 170 includes an upper surface, a lower surface, and a side surface disposed between the upper surface and the lower surface. At this time, the lower surface of the first protective layer 170 may face the upper surface of the insulating layer (for example, the uppermost insulating layer). In addition, the plurality of posts 190 may face a side surface of the first protective layer 170. In addition, the side surface of the first protective layer 170 may include a protruding portion protruding between the plurality of posts.

For example, the side surface of the first protective layer 170 may include a first side surface extending in the first direction, a second side surface extending in the first direction and spaced apart from the first side surface, a third side surface extending in a second direction perpendicular to the first direction, and a fourth side surface extending in the second direction and spaced apart from the third side surface. At this time, the protruding surface of the first protective layer 170 may be provided on the first side surface and the third side surface.

Accordingly, the third side surface of the first protective layer 170 may have a first surface having a first separation distance along the first direction from the plurality of posts, a second surface having a second separation distance smaller than the first separation distance along the first direction from the plurality of posts, and a third surface having a third separation distance larger than the first separation distance along the first direction from the plurality of posts. This is because the third side surface of the first protective layer 170 may be provided with all of the first portion 170a, the second portion 170b, and the third portion 170c.

Furthermore, a separation distance along the first direction between the fourth side surface of the first protective layer 170 and the plurality of posts may be uniform. This may be a design considering a direction in which the circuit board is bent, and at least one side surface of the first protective layer 170 may not have a protrusion or a concave surface.

In addition, the second side surface of the first protective layer 170 may include a concave surface that is concave toward the first side surface of the first protective layer 170.

Meanwhile, referring to FIG. 5, the post 190 is disposed on the first pad 121 located in the first region R1. The post 190 may have a third width W3 smaller than the first width W1 of the first pad 121.

Specifically, the post 190 may be disposed on the first pad 121 that is entirely open through the first opening 171 of the first protective layer 170. Through this, the embodiment may form the post 190 using a separate dry film as a mask, rather than forming the post 190 using the opening of the first protective layer 170 as a mask. At this time, the dry film may have a larger thickness while allowing the formation of a smaller opening compared to the solder resist. Through this, the embodiment may allow the post 190 to have a smaller width than the first pad 121.

In addition, the embodiment can form the post 190 by using a seed layer used for electroplating the first pad 121. Through this, no seed layer for electroplating the post 190 exists between the first pad 121 and the post 190 of the embodiment. In addition, the embodiment can form the post 190 by considering only an opening size of the dry film by removing a separate seed layer for electroplating the post 190. Through this, the embodiment can allow the third width W3 of the post 190 to be smaller than the first width W1 of the first pad 121.

The third width W3 of the post 190 can satisfy a range of 60% to 95% of the first width W1 of the first pad 121. Preferably, the third width W3 of the post 190 can satisfy a range of 65% to 92% of the first width W1 of the first pad 121. The third width W3 of the post 190 can satisfy a range of 70% to 90% of the first width W1 of the first pad 121.

If the third width W3 of the post 190 is smaller than 60% of the first width W1 of the first pad 121, the heat dissipation characteristics of the circuit board may deteriorate. If the third width W3 of the post 190 is less than 60% of the first width W1 of the first pad 121, the first external substrate may not be stably disposed on the circuit board. If the third width W3 of the post 190 is less than 60% of the first width W1 of the first pad 121, a height H1 of the post 190 may not be formed above a certain level.

If the third width W3 of the post 190 is greater than 95% of the first width W1 of the first pad 121, the post 190 may have a width greater than the first pad 121 due to a process error in a process of forming the post 190. In this case, a circuit short circuit problem in which two adjacent posts 190 are connected to each other may occur. That is, as the spacing between two adjacent posts 190 decreases, an electrical reliability problem may occur.

Specifically, referring to FIG. 6, the post 190 is disposed on the first pad 121 with a width smaller than the width of the first pad 121. In addition, the post 190 is disposed on the first pad 121 with a certain height H1.

The height H1 may mean a vertical distance from an upper surface of the post 190 to a lower surface of the post 190. The height H1 of the post 190 may exceed 100 µm, exceed 120 µm, exceed 140 µm, exceed 160 µm, or exceed 200 µm. For example, the height H1 of the post 190 may satisfy a range of 100 µm to 220 µm. Preferably, the height H1 of the post 190 can satisfy a range of 110 µm to 215 µm. More preferably, the height of the post 190 can satisfy a range of 115 µm to 210 µm.

If the height H1 of the post 190 is less than 100 µm, the first external substrate may not be stably bonded onto the post 190. If the height H1 of the post 190 is less than 100 µm, a distance between the first external substrate and the circuit board 100 decreases, and thus, signal transmission characteristics may deteriorate due to signal interference between the first external substrate and the circuit board 100. In addition, if the height H1 of the post 190 exceeds 220 µm, the rigidity of the post 190 may deteriorate. In addition, if the rigidity of the post 190 deteriorates, a physical reliability problem, such as collapse, may occur during a bonding process with the first external substrate. If the height H1 of the post 190 exceeds 220µm, the thickness of the circuit board 100 and the thickness of the semiconductor package may increase.

The post 190 is composed of one metal layer. Specifically, the post 190 may include only an electrolytic plating layer without including an electroless plating layer such as a chemical copper plating layer.

In addition, the first circuit layer 120 is composed of at least two metal layers. The first pad 121 and the second pad 122 of the first circuit layer 120 may have a same layer structure. Furthermore, the first through electrode 161 may include two metal layers corresponding to the first circuit layer 120.

That is, each of the first pad 121 and the second pad 122 of the first circuit layer 120 may include a first metal layer 120-1 and a second metal layer 120-2.

Furthermore, the first through electrode 161 may include a third metal layer 161-1 corresponding to the first metal layer 120-1 of the first circuit layer 120 and a fourth metal layer 161-2 corresponding to the second metal layer 120-2.

At this time, the first metal layer 120-1 and the third metal layer 161-1 may substantially mean one layer, and may be distinguished according to an arrangement position. In addition, the second metal layer 120-2 and the fourth metal layer 161-2 may also substantially mean one metal layer, and may be distinguished according to an arrangement position.

In addition, the first metal layer 120-1 may be substantially two layers. The first metal layer 120-1 may be two metal layers including a same metal layer as the third metal layer 161-1 on a copper foil (Cu foil).

In addition, the first metal layer 120-1 may be one layer of copper foil (Cu foil).

Accordingly, only the first metal layer 120-1 and the second metal layer 120-2 will be described below.

The first metal layer 120-1 of the first circuit layer 120 may be a seed layer. The first metal layer 120-1 of the first circuit layer 120 may be a chemical copper plating layer. The first metal layer 120-1 of the first circuit layer 120 may be a copper foil layer. The first metal layer 120-1 of the first circuit layer 120 may include both the copper foil layer and the chemical copper plating layer.

A thickness of the first metal layer 120-1 of the first circuit layer 120 may satisfy a range of 1.0 µm to 3.0 µm. Preferably, the thickness of the first metal layer 120-1 of the first circuit layer 120 may satisfy a range of 1.2 µm to 2.8 µm. More preferably, the thickness of the first metal layer 120-1 of the first circuit layer 120 may satisfy a range of 1.5 µm to 2.5 µm.

If the thickness of the first metal layer 120-1 of the first circuit layer 120 is less than 1.0 µm, the first metal layer 120-1 of the first circuit layer 120 may not function as a seed layer. If the thickness of the first metal layer 120-1 of the first circuit layer 120 is less than 1.0 µm, it may be difficult to form a first metal layer 120-1 of a uniform thickness on the upper surface of the first insulating layer 110.

If the thickness of the first metal layer 120-1 of the first circuit layer 120 exceeds 3.0 µm, a process time for forming the first metal layer 120-1 of the first circuit layer 120 may increase, and the yield may decrease accordingly. In addition, if the thickness of the first metal layer 120-1 of the first circuit layer 120 exceeds 3.0 µm, an etching time of the first metal layer 120-1 in a process of forming the first circuit layer 120 may increase. In addition, if the thickness of the first metal layer 120-1 of the first circuit layer 120 exceeds 3.0 µm, deformation of the second metal layer 120-2 of the first circuit layer 120 may occur during etching of the first metal layer 120-1 of the first circuit layer 120. Here, the deformation of the second metal layer 120-2 of the first circuit pattern layer 120 may mean that a difference between a width of the upper surface and a width of the lower surface of the second metal layer 120-2 increases as a side portion of the second metal layer 120-2 is also etched during the etching of the first metal layer 120-1. In addition, if the thickness of the first metal layer 120-1 of the first circuit layer 120 exceeds 3.0 µm, an etching amount in the etching process of the first metal layer 120-1 increases, and accordingly, a depth of a dent (e.g., undercut) formed at a side portion of the first metal layer 120-1 and a side portion of the second metal layer 120-2 may increase. For example, if the etching amount in the etching process of the first metal layer 120-1 increases, a difference between the width of the first metal layer 120-1 and the width of the second metal layer 120-2 may increase. In addition, if the difference between the width of the first metal layer 120-1 and the width of the second metal layer 120-2 increases, the electrical characteristics may deteriorate due to increased signal transmission loss. In addition, if the difference between the width of the first metal layer 120-1 and the width of the second metal layer 120-2 increases, dendrites may be formed by electromigration, thereby deteriorating the electrical characteristics and/or physical characteristics of the first circuit pattern layer 120.

The second metal layer 120-2 of the first circuit layer 120 may be an electrolytically plated layer in which the first metal layer 120-1 is electrolytically plated as a seed layer. The second metal layer 120-2 of the first circuit layer 120 may be formed on the first metal layer 120-1 with a predetermined thickness. The second metal layer 120-2 of the first circuit layer 120 may include a same metal as the first metal layer 120-1 of the first circuit layer 120, but is not limited thereto. For example, the first metal layer 120-1 and the second metal layer 120-2 of the first circuit layer 120 may each include copper.

A thickness of the second metal layer 120-2 of the first circuit layer 120 may correspond to a value obtained by subtracting a thickness of the first metal layer 120-1 from a thickness range of the first circuit layer 120. In addition, since the thickness range of the first circuit layer 120 has already been described above, its description will be omitted.

In addition, the post 190 may be formed on the second metal layer 120-2 of the first circuit layer 120 by electrolytically plating the first metal layer 120-1 as a seed layer. For example, the post 190 may include only the third metal layer. In addition, the third metal layer may be formed on the second metal layer 120-2 with a predetermined height H1 by electrolytically plating the first metal layer 120-1 as a seed layer. That is, the lower surface of the third metal layer is in direct contact with the upper surface of the second metal layer 120-2. In addition, the upper surface of the third metal layer is positioned higher than the upper surface of the first protective layer 170. This may mean that the post 190 does not include a seed layer between the second metal layer 120-2 and the third metal layer.

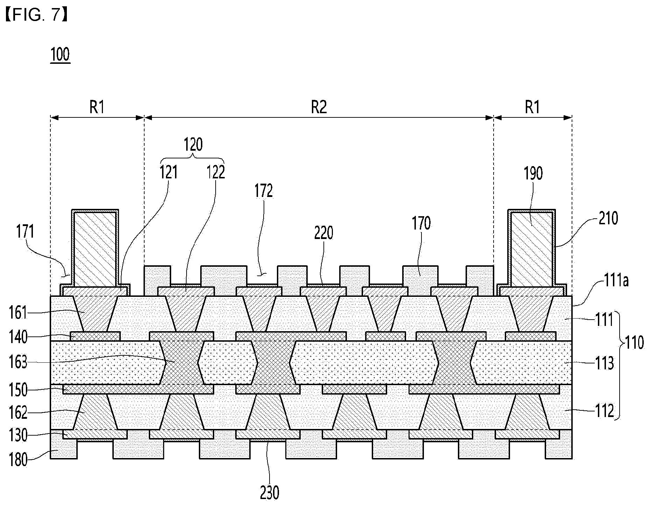

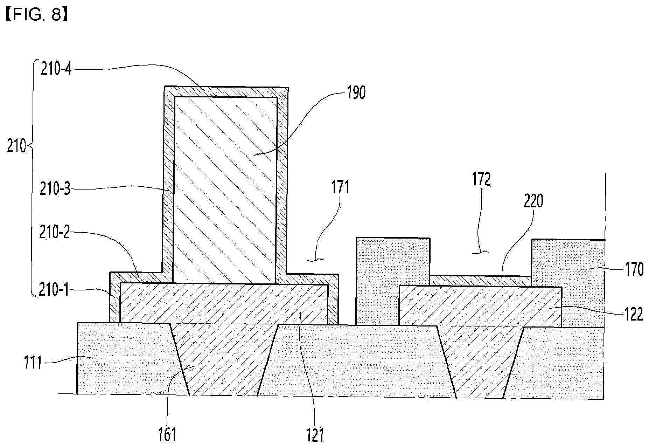

FIG. 7 is a cross-sectional view showing a circuit board according to a second embodiment, and FIG. 8 is an enlarged view showing a partial region of FIG. 7.

Referring to FIGS. 7 and 8, the circuit board of the second embodiment may be different from the circuit board of FIG. 2 in that a surface treatment layer is disposed. Hereinafter, descriptions of parts that are substantially the same as the circuit board of FIG. 2 will be omitted.

The circuit board of the second embodiment may include a surface treatment layer.

Specifically, the circuit board may include a first surface treatment layer 210.

The first surface treatment layer 210 may be disposed on the first pad 121 and the post 190.

Specifically, the first protective layer 170 is not disposed in a region where the first pad 121 and the post 190 are disposed. Therefore, the first surface treatment layer 210 may cover an exposed surface of the first pad 121 and the post 190 as a whole.

The first surface treatment layer 210 may be divided into a plurality of portions.

For example, the first surface treatment layer 210 may include a first portion 210-1 disposed on a side surface of the first pad 121, a second portion 120-2 disposed on an upper surface of the first pad 121, a third portion 210-3 disposed on a side surface of the post 190, and a fourth portion 210-4 disposed on an upper surface of the post 190.

In addition, the circuit board may include a second surface treatment layer 220. The second surface treatment layer 220 may be disposed on the second pad 122. Specifically, the second surface treatment layer 220 may be disposed on an upper surface of the second pad 122 opened through the second opening 172 of the first protective layer 170.

In addition, the circuit board may include a third surface treatment layer 230. The third surface treatment layer 230 may be disposed under the pad of the second circuit layer 130. Specifically, the third surface treatment layer 230 may be disposed on the lower surface of the pad of the second circuit layer 130 that is opened through the opening of the second protective layer 180.

The first surface treatment layer 210, the second surface treatment layer 220, and the third surface treatment layer 230 may be OSP (Organic Solderability Preservative) layers. For example, the first surface treatment layer 210, the second surface treatment layer 220, and the third surface treatment layer 230 may be organic coating layers coated with an organic material such as benzimidazole. However, the embodiment is not limited thereto. For example, the first surface treatment layer 210, the second surface treatment layer 220, and the third surface treatment layer 230 may be plating layers. For example, the first surface treatment layer 210, the second surface treatment layer 220, and the third surface treatment layer 230 may include at least one of a nickel (Ni) plating layer, a palladium (Pd) plating layer, and a gold (Au) plating layer.

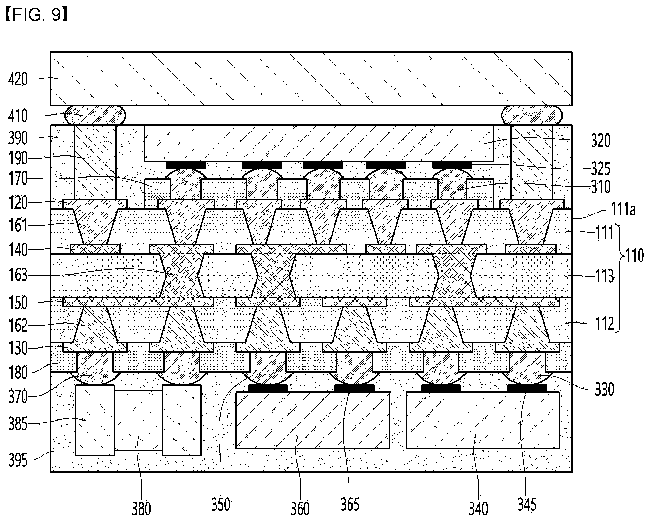

FIG. 9 is a drawing showing a semiconductor package according to a first embodiment.

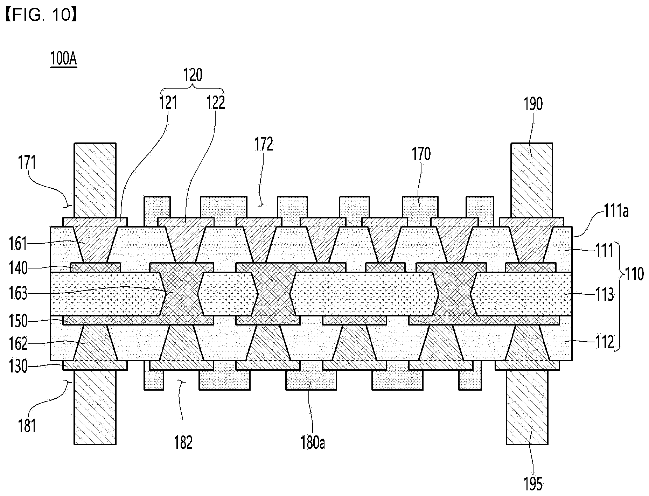

Referring to FIGS. 9 and 10, the semiconductor package includes the circuit board 100 of FIG. 2.

The semiconductor package of the first embodiment may have a structure in which a plurality of chips and a first external substrate are coupled on the circuit board 100.

To this end, the circuit board 100 includes a first pad 121 and a second pad 122 of the first circuit layer 120. In addition, a post 190 is disposed on the first pad 121.

In addition, the semiconductor package includes a first connection part 310 disposed on the second pad 122. The first connection part 310 may have a hexahedral shape. For example, a cross-section of the first connection part 310 may include a square shape. The cross-section of the first connection part 310 may include a rectangle or a square. For example, the first connection part 310 may include a spherical shape. For example, a cross-section of the first connection part 310 may include a circular shape or a semicircular shape. For example, a cross-section of the first connection part 310 may include a partially or entirely rounded shape. A cross-sectional shape of the first connection part 310 may be flat at one side surface and curved at the other side surface. The first connection part 310 may be a solder ball, but is not limited thereto.

The semiconductor package may include a first chip 320 disposed on the first connection part 310. The first chip 320 may include a terminal 325. The terminal 325 of the first chip 320 may be electrically connected to the second pad 122 through the first connection part 310.

The semiconductor package may include a second connection part 330 disposed under pads of a first group of the second circuit layer 130. In addition, a second chip 340 may be mounted on the second connection part 330. The second chip 340 may include a terminal 345. The terminal 345 of the second chip 340 may be electrically connected to the pads of the first group through the second connection part 330.

The semiconductor package may include a third connection part 350 disposed under pads of a second group of the second circuit layer 130. In addition, a third chip 360 may be mounted on the third connection part 350. The third chip 360 may include a terminal 365. The terminal 365 of the third chip 360 may be electrically connected to the pads of the second group through the third connection part 350.

The semiconductor package may include a fourth connection part 370 disposed under the pad of a third group of the second circuit layer 130. In addition, a fourth chip 380 may be mounted on the fourth connection part 370. The fourth chip 380 may include a terminal 385. The terminal 385 of the fourth chip 380 may be electrically connected to the pad of the third group through the fourth connection part 370.

At least one of the first chip 320, the second chip 340, the third chip 360, and the fourth chip 380 may include a logic chip. For example, at least one of the first chip 320, the second chip 340, the third chip 360, and the fourth chip 380 may include an application processor chip. For example, at least one of the first chip 320, the second chip 340, the third chip 360, and the fourth chip 380 may include an analog-to-digital converter or an ASIC (application-specific IC). For example, at least one of the first chip 320, the second chip 340, the third chip 360, and the fourth chip 380 may include a memory chip. The memory chip may be a stacked memory such as HBM. For example, the memory chip may include a volatile memory (e.g., DRAM), a non-volatile memory (e.g., ROM), a flash memory, and the like. In addition, at least one of the first chip 320, the second chip 340, the third chip 360, and the fourth chip 380 may include at least one of a drive IC chip, a diode chip, a power IC chip, a touch sensor IC chip, a multilayer ceramic condenser (MLCC) chip, a ball grid array (BGA) chip, and a chip condenser. For example, at least one of the first chip 320, the second chip 340, the third chip 360, and the fourth chip 380 may be an active device, and at least one of the other may be a passive device.

The semiconductor package may include a first molding layer 390.

The first molding layer 390 may mold the first chip 320 and the post 190. At this time, the first protective layer 170 is not disposed in the first region R1 of the first insulating layer 111. Accordingly, the first molding layer 390 can mold the first region R1 of the first insulating layer 111. For example, the first molding layer 390 can mold the upper surface of the first region R1 of the first insulating layer 111. For example, accordingly, at least a portion of the upper surface of the first region R1 of the first insulating layer 111 can be in direct contact with the first molding layer 390. In addition, the first molding layer 390 can mold the first pad 121 disposed in the first region R1 and the post 190 disposed on the first pad 121. For example, at least a portion of the upper surface and the side surface of the first pad 121 can be in direct contact with the first molding layer 390. For example, the side surface of the post 190 may be in direct contact with the first molding layer 390. At this time, as in FIG. 7, when the first surface treatment layer 210 is included, the first molding layer 390 may mold the upper surface of the first region R1 of the first insulating layer 111 and the first surface treatment layer 210.

The first molding layer 390 may include an open region. For example, the first molding layer 390 may include a first open region that opens the upper surface of the post 190. For example, the first molding layer 390 may include a second open region that opens the upper surface of the first chip 320. The first open region and the second open region can be formed by grinding the upper surface of the first molding layer 390 and the upper surface of the post 190 so that the upper surface of the first molding layer 390 and the upper surface of the post 190 have a same height as the upper surface of the first chip 320 in a state in which the first molding layer 390 is formed.

However, the first molding layer 390 can mold the upper surface of the first chip 320 as a whole, and thus, can include only the first open region opening the upper surface of the post 190.

The semiconductor package can include a second molding layer 395.

The second molding layer 395 can be disposed on the lower surface of the second insulating layer 112. The second molding layer 395 can mold the second chip 340, the third chip 360, and the fourth chip 380.

The first molding layer 390 and the second molding layer 395 may be EMC (Epoxy Mold Compound), but the embodiment is not limited thereto.

At this time, the first molding layer 390 and the second molding layer 395 may have a low dielectric constant in order to improve heat dissipation characteristics. For example, the dielectric constant (Dk) of the first molding layer 390 and the second molding layer 395 may be 0.2 to 10. For example, the dielectric constant (Dk) of the first molding layer 390 and the second molding layer 395 may be 0.5 to 8. For example, the dielectric constant (Dk) of the first molding layer 390 and the second molding layer 395 may be 0.8 to 5. Accordingly, in the embodiment, the first molding layer 390 and the second molding layer 395 have low dielectric constant, so that heat generated from the first to fourth chips 320, 340, 360, and 380 can be efficiently dissipated to the outside.

The semiconductor package may include a fifth connection part 410. The fifth connection part 410 may be disposed on the upper surface of the post 190 that is opened through the first open region of the first molding layer 390.

The semiconductor package may include a first external substrate 420 disposed on the fifth connection part 410. The first external substrate 420 may be a main board. For example, the first external substrate 420 may be a motherboard of an electronic device.

FIG. 10 is a cross-sectional view showing a circuit board according to a third embodiment.

Referring to FIG. 10, the circuit board 100A of the third embodiment may be different from the circuit board 100 of FIG. 2 in that the circuit board 100A has a vertically symmetrical structure. Hereinafter, descriptions of parts that are substantially the same as the circuit board of FIG. 2 will be omitted.

The circuit board 100A may have a first protective layer 170 including a first opening 171 and a second opening 172 disposed on the first insulating layer 111. In addition, a first post 190 may be disposed on the first pad 121 of the first circuit layer 120.

The circuit board 100A may have a second protective layer 180a and a second post 195 disposed on the lower side of the circuit board 100A corresponding to the first protective layer 170 and the first post 190.

Specifically, the second insulating layer 112 may also include a first region R1 and a second region R2 corresponding to the first insulating layer 111. In addition, the second protective layer 180a may include a third opening 181 that entirely opens the first region R1. In addition, the second protective layer 180a may include a fourth opening 182 that partially opens the second region R2. That is, the second protective layer 180a may have a structure corresponding to the first protective layer 170. At this time, it is said that the first regions and the second regions of the first insulating layer 111 and the second insulating layer 112 overlap each other in a vertical direction, but the embodiment is not limited thereto. For example, the first region in the first insulating layer and the first region in the second insulating layer may have different areas.

The second circuit layer 130 may include a third pad disposed under the first region R1 of the second insulating layer 112 and a fourth pad disposed under the second region R2 of the second insulating layer 112. In addition, the third pad of the second circuit layer 130 may have a structure corresponding to the first pad 121 of the first circuit layer 120. The fourth pad of the second circuit layer 130 may have a structure corresponding to the second pad 122 of the first circuit layer 120.

In addition, a second post 195 is disposed under the third pad of the second circuit layer 130. The second post 195 may have a structure corresponding to the first post 190. Since the first post 190 has already been described in the previous embodiment, a description of the second post will be omitted.

The circuit board 100A of the third embodiment may have posts disposed on both sides of the substrate. The circuit board 100A of the third embodiment may be applied to a POP structure.

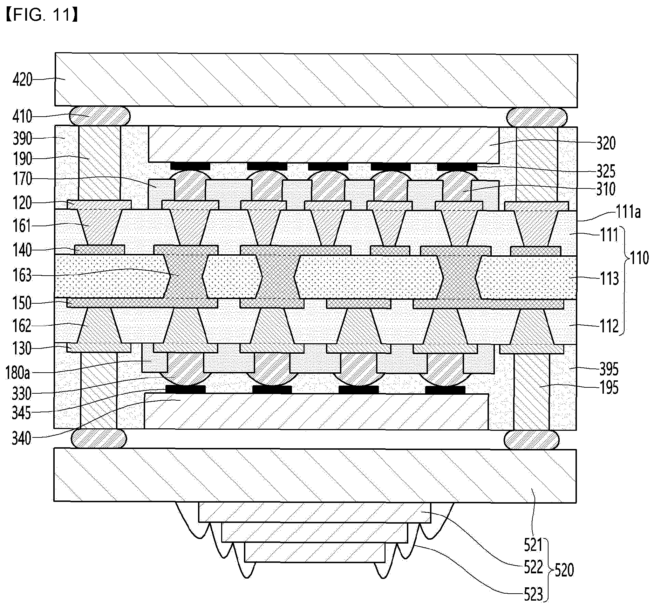

FIG. 11 is a cross-sectional view showing a semiconductor package according to a second embodiment.

Referring to FIG. 11, the semiconductor package according to the second embodiment may have a structure in which a second external substrate 520 is additionally disposed in the semiconductor package of the first embodiment.

A sixth connection part 510 may be disposed on the lower surface of the second post 195 of the circuit board 100A.

To this end, the second molding layer 395 may include a third open region that opens the lower surface of the second post 195.

A second external substrate 520 may be coupled to the sixth connection part 510. The second external substrate 520 may be a memory package. To this end, the second external substrate 520 may include a memory substrate 521, a memory chip 522 attached to the memory substrate 521, and a connecting member 543 connecting the memory substrate 521 and the memory chip 522.

However, the embodiment is not limited thereto, and the second external substrate 520 may be an interposer disposed between the memory package and the second post 195.

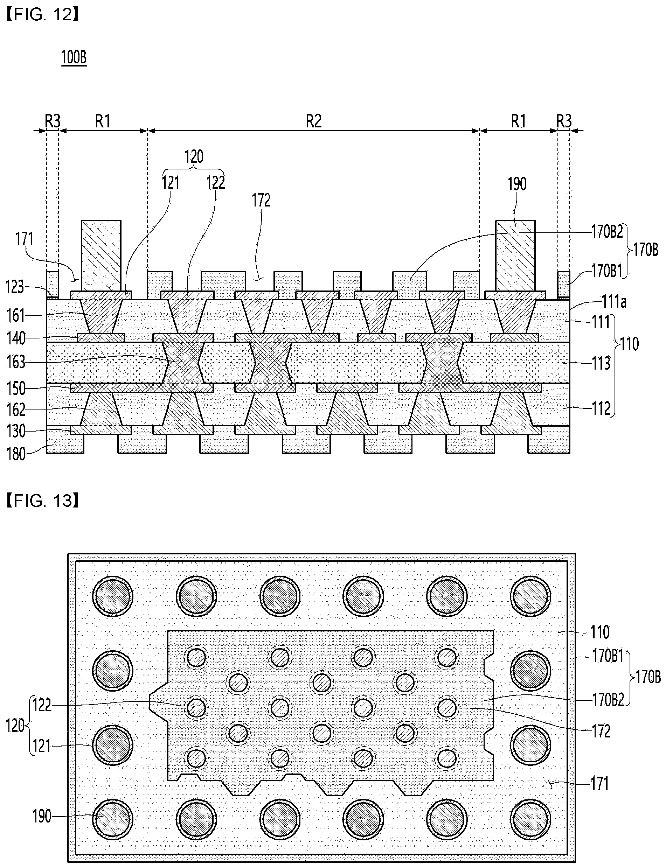

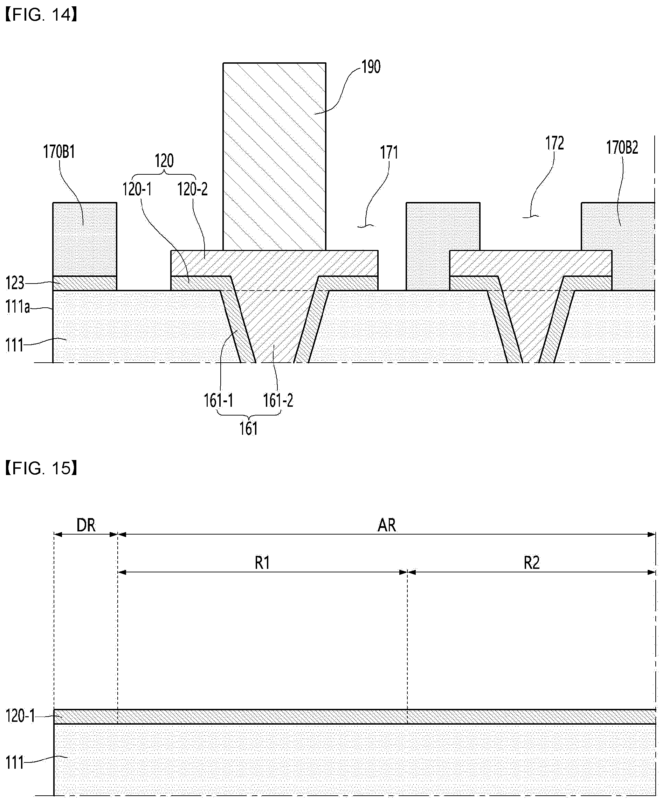

FIG. 12 is a cross-sectional view showing a circuit board according to a fourth embodiment, FIG. 13 is a top plan view of the circuit board of FIG. 12, and FIG. 14 is an enlarged view of a partial region of a circuit board of FIG. 12.

Referring to FIGS. 12 to 14, the circuit board 100B of the fourth embodiment is different from the circuit board 100 of FIG. 2 in that the first protective layer of the circuit board 100B includes a reinforcing pattern. Hereinafter, descriptions of parts that are substantially the same as the circuit board of FIG. 2 will be omitted.

In the circuit board of the first embodiment, the first protective layer 170 was not entirely disposed in the first region R1 including the circumference 111a of the upper surface of the first insulating layer 111. That is, the first protective layer 170 of the circuit board of the first embodiment includes a first opening 171 that entirely opened the first region R1 including the circumference 111a of the upper surface of the first insulating layer 111.

Unlike this, the first protective layer 170b in the fourth embodiment may include a plurality of protective members.

The first protective layer 170b may include an outer protective member 170B1. The outer protective member 170B1 of the first protective layer 170b may be disposed in a circumferential region or edge region adjacent to the circumference 111a of the upper surface of the first insulating layer 111.

Specifically, the first insulating layer 111 may further include a third region R3 in addition to the first region R1 and the second region R2.

The third region R3 may mean a circumferential region or edge region adjacent to the circumference 111a while including the circumference 111a of the upper surface of the first insulating layer 111 in the first region R1 of the first embodiment. That is, the first protective layer 170b includes an outer protective member 170B1 disposed in the third region R3 adjacent to the circumference 111a while opening the first region R1 entirely. The first protective layer 170b may be disposed along the circumferential direction of the first insulating layer 111 at the edge region of the upper surface of the first insulating layer 111. That is, the outer protective member 170B1 of the first protective layer 170b may have a closed loop shape including an open region that entirely opens the first region R1 and the second region R2.

The outer protective member 170B1 of the first protective layer 170b may also be referred to as a reinforcing member that improves the rigidity of the circuit board 100B. The outer protective member 170B1 of the first protective layer 170b may be formed by controlling a sawing line in a sawing process that separates a substrate strip into units during a process of manufacturing the circuit board of the embodiment.

The protective member 170B2 of the first protective layer 170b may be disposed in the second region R2 of the first insulating layer 111. The protective member 170B2 of the first protective layer 170b corresponds to the first protective layer 170 of the first embodiment. Accordingly, a detailed description thereof will be omitted.

The outer protective member 170B1 may be horizontally spaced from the protective member 170B2 with the first opening 171 therebetween. Here, the first opening 171 may be referred to as a separation region between the inner side surface of the outer protective member 170B1 and the outer side surface of the protective member 170B2.

That is, the first opening 171 may also be referred to as a separation space that separates the outer protective member 170B1 and the protective member 170B2. The outer protective member 170B1 may be disposed in a closed loop shape along the circumferential direction of the first insulating layer 111. Accordingly, the first opening 171 may be provided between the inner side surface of the outer protective member 170B1 and the outer side surface of the protective member 170B2 in a closed loop shape.

At this time, the outer side surface of the protective member 170B2 includes an outwardly protruding portion and an inwardly concave portion as described in the previous embodiment. Therefore, a horizontal width of the first opening 171 may include different widths along the outer side surface of the protective member 170B2.

That is, the outer protective member 170B1 is provided along the edge of the upper surface of the substrate corresponding to the insulating layer, and the protective member 170B2 is provided inside the outer protective member 170B1 with the separation region therebetween. At this time, the separation region between the inner side surface of the outer protective member 170B1 and the outer side surface of the protective member 170B2 may include a first separation region having a first width along the horizontal direction and a second separation region having a second width different from the first width. This may be due to a concave surface and/or a convex surface provided at the outer side surface of the protective member 170B2. In addition, the separation region is provided as a closed loop along the outer side surface of the protective member 170B2.

At this time, the outer side surface of the protective member 170B2 includes a protruding surface protruding toward the inner side surface of the outer protective member 170B1. In addition, the protruding surface of the protective member 170B2 is provided in the second separation region, and the first width may be larger than the second width.

At this time, the protruding surface of the protective member 170B2 may include a first protruding surface protruding toward the inner side surface of the outer protective member 170B1 with a first protrusion width, and a second protruding surface protruding toward the inner side surface of the outer protective member 170B1 with a second protrusion width larger than the first protrusion width. In this case, the first separation region may correspond to the first protruding surface, and the second separation region may correspond to the second protruding surface.

In addition, the outer side surface of the protective member 170B2 may include a concave surface concave toward the inner side of the protective member 170B2. At this time, the concave surface of the protective member 170B2 is provided in the first separation region, and the first width may be larger than the second width.

Meanwhile, the inner side surface of the outer protective member 170B1 may include a first inner side surface, a second inner side surface facing the first inner side surface, and a third inner side surface and a fourth inner side surface disposed between the first inner side surface and the second inner side surface and facing each other.

In addition, the outer side surface of the second protective member 170B2 may include a first outer side surface adjacent to the first inner side surface, a second outer side surface adjacent to the second inner side surface, a third outer side surface adjacent to the third inner side surface, and a fourth outer side surface adjacent to the fourth inner side surface.

At this time, a separation region between the first inner side surface of the outer protective member 170B1 and the first outer side surface of the second protective member 170B2 may include the first and second separation regions.

In addition, the first circuit layer 120 includes a first pad 121 and a second pad 122, respectively.

At this time, the first circuit layer 120 may include a dummy pattern 123. The dummy pattern 123 may be disposed in the third region R3 of the first insulating layer 111. The dummy pattern 123 may be covered by the outer protective member 170B1.

The dummy pattern 123 may have a planar shape corresponding to the outer protective member 170B1. For example, the dummy pattern 123 may be provided with a closed loop shape along the circumference 111a.

The dummy pattern 123 may be a part of a seed layer used for electroplating the first pad 121, the second pad 122, and the post 190.

That is, the electroplating process of the post 190 in the fourth embodiment may be performed in a state in which the outer protective member 170B1 is disposed corresponding to the third region R3. In addition, since the seed layer is finally removed while the outer protective member 170B1 is disposed, the seed layer disposed under the outer protective member 170B1 is not removed. Accordingly, the first circuit layer 120 of the circuit board of the fourth embodiment may further include a dummy pattern 123 disposed under the outer protective member 170B1 of the third region R3. The dummy pattern 123 may correspond to the first metal layer 120-1 of the first circuit layer 120. That is, the dummy pattern 123 may have a same thickness as the first metal layer 120-1 of the first pad 121 and the second pad 122 of the first circuit layer 120.

The embodiment has a structure in which the dummy pattern 123 is disposed in the third region R3 of the upper surface of the first insulating layer 111 of the circuit board. In addition, the dummy pattern 123 may have a function of suppressing bending of the circuit board and improving warpage characteristics. For example, the dummy pattern 123 may function as a rigid member that improves the rigidity of the circuit board. In addition, the outer protective member 170B1 may have a protective function of protecting an outermost edge region of the upper surface of the first insulating layer 111.

A reason why the circuit board of the fourth embodiment can have the outer protective member 170B1 and the dummy pattern 123 will be described in more detail in a description of the manufacturing method of the circuit board below.

### - Manufacturing method of the circuit board -

FIGS. 15 to 28 are drawings for explaining the manufacturing method of the circuit board of the first embodiment illustrated in FIG. 2 in the order of processes. Hereinafter, the manufacturing method of the circuit board of the first embodiment will be described with reference to FIGS. 15 to 28. Furthermore, in the description of the manufacturing method of the circuit board of the first embodiment, a method of forming the first circuit layer and a dummy part of the first protective layer of the fourth embodiment will also be described.

In addition, the following description will focus on a process of forming the first circuit layer 120, the first protective layer 170, and the post 190 on an upper side of the first insulating layer 111 in the circuit board.

Referring to FIG. 15, the embodiment prepares the first insulating layer 111. Preferably, a process of preparing the first insulating layer 111 may mean a process of laminating the first insulating layer 111 on the third insulating layer 113 while the third circuit layer 140 is disposed on the third insulating layer 113. Next, the embodiment may form a first metal layer 120-1 on the first insulating layer 111. The first metal layer 120-1 may mean a copper foil layer disposed on the first insulating layer 111. Alternatively, the first metal layer 120-1 may be an electroless plating layer formed by performing electroless plating on the first insulating layer 111. For example, the first metal layer 120-1 may be a chemical copper plating layer. Alternatively, the first metal layer 120-1 may include both the copper foil layer and the chemical copper plating layer.

At this time, the circuit board of the embodiment can be manufactured in strip units or panel units. That is, the strip includes a plurality of circuit boards, and the panel includes a plurality of strips.

Accordingly, the first insulating layer 111 can be divided into a plurality of regions. For example, the first insulating layer 111 includes a plurality of effective regions AR corresponding to circuit board regions, and a dummy region DR disposed between the plurality of effective regions AR. Finally, the plurality of circuit boards can be separated by performing sawing using a line between the effective region AR and the dummy region DR as a sawing line. In addition, the effective region AR can include the first region R1 and the second region R2 of the circuit board 100 as described above. The first region R1 of the circuit board 100 can mean a region adjacent to the dummy region DR.

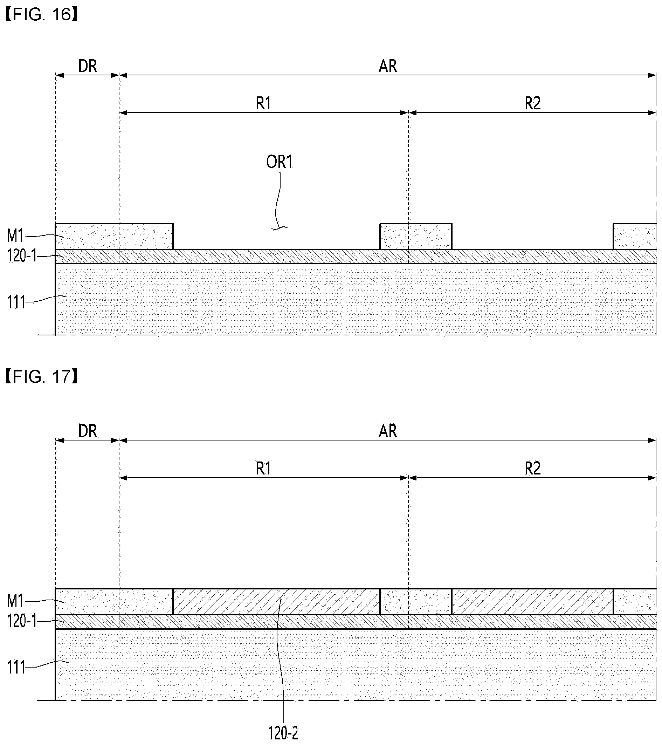

Next, referring to FIG. 16, the embodiment forms a first mask M1 on the first metal layer 120-1. The first mask M1 may be disposed on the effective region AR and the dummy region DR. At this time, the first mask M1 may be provided on the effective region AR and may include an open region OR1 that opens a region where the first circuit layer 120 is to be formed.

Next, referring to FIG. 17, the embodiment forms a second metal layer 120-2 that fills the open region OR1 of the first mask M1 using the first metal layer 120-1 as a seed layer.

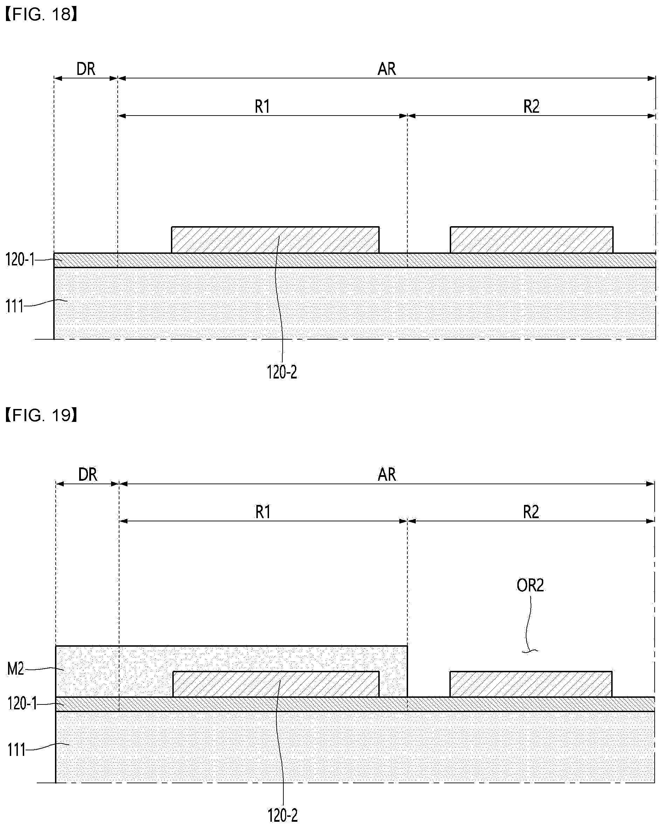

Next, referring to FIG. 18, the embodiment may perform a process of removing the first mask M1.

Next, referring to FIG. 19, the embodiment may perform a process of forming a second mask M2. The second mask M2 may include an open region OR2. The open region OR2 of the second mask M2 may vertically overlap the first metal layer 120-1 and the second metal layer 120-2 which vertically overlap the second region R2 of the effective region AR. For example, the second mask M2 may cover the first metal layer 120-1 and the second metal layer 120-2 disposed in the first region R1 of the effective region AR. In addition, the second mask M2 may cover the first metal layer 120-1 disposed in the dummy region DR. In addition, the first metal layer 120-1 of the first region R1 covered through the second mask M2 and the first metal layer 120-1 of the dummy region DR can be used as a seed layer for electroplating the post 190 later.

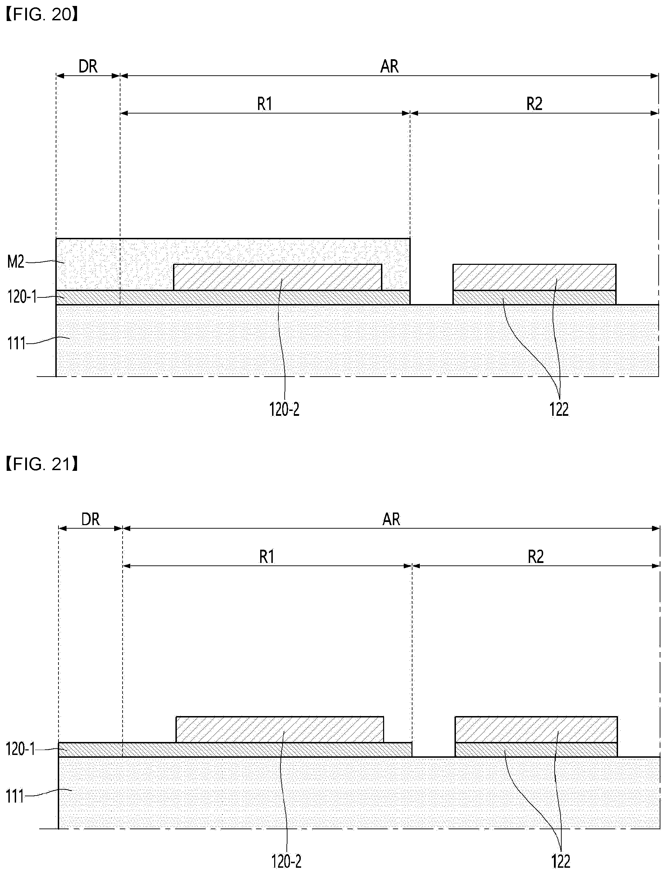

Next, referring to FIG. 20, the embodiment can perform a process of removing the first metal layer 120-1 exposed through the open region OR2 of the second mask M2 by etching. Specifically, the embodiment can remove a portion of the first metal layer 120-1 disposed in the second region R2 that does not vertically overlap with the second metal layer 120-2 by etching. Through this, the embodiment can form the second pad 122 of the first circuit layer 120 including the first metal layer 120-1 and the second metal layer 120-2 in the second region R2.

Next, referring to FIG. 21, the embodiment can perform a process of removing the second mask M2. Through this, the first metal layer 120-1 disposed in the first region R1 and the first metal layer 120-1 disposed in the dummy region DR can be opened.

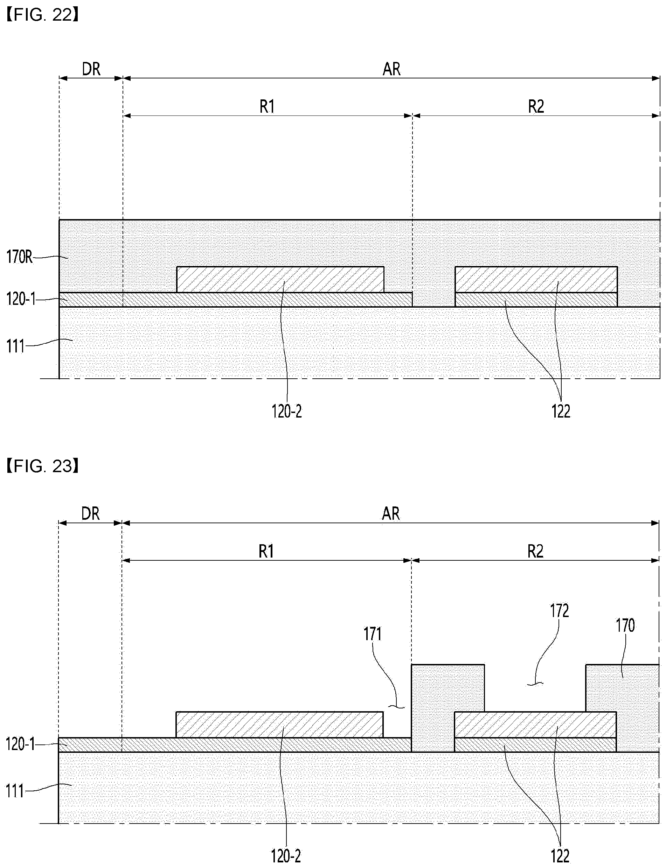

Next, referring to FIG. 22, the embodiment can perform a process of forming a resist layer 170R entirely on the effective region AR and the dummy region DR. The resist layer 170R may refer to a layer before the first opening 171 and the second opening 172 are formed in the first protective layer 170 of the embodiment. The resist layer 170R may cover the first metal layer 120-1 and the second metal layer 120-2 in the first region R1. The resist layer 170R may cover the first insulating layer 111 and the second pad 122 in the second region R2. In addition, the resist layer 170R may cover the first metal layer 120-1 in the dummy region DR.

Next, referring to FIG. 23, the embodiment may perform a process of forming a first opening 171 that completely opens the first region R1 by exposing and developing the resist layer 170R. In addition, the embodiment may perform a process of forming a second opening 172 that partially opens the second pad 122 disposed in the second region R2. At this time, when forming the first opening 171, the resist layer 170R on the dummy region DR may also be completely removed. However, the embodiment is not limited thereto.

For example, in order to manufacture the circuit board of the fourth embodiment, a portion of the resist layer 170R disposed in the dummy region DR adjacent to the first region R1 (for example, the third region R3 of the circuit board of the fourth embodiment) may not be removed.

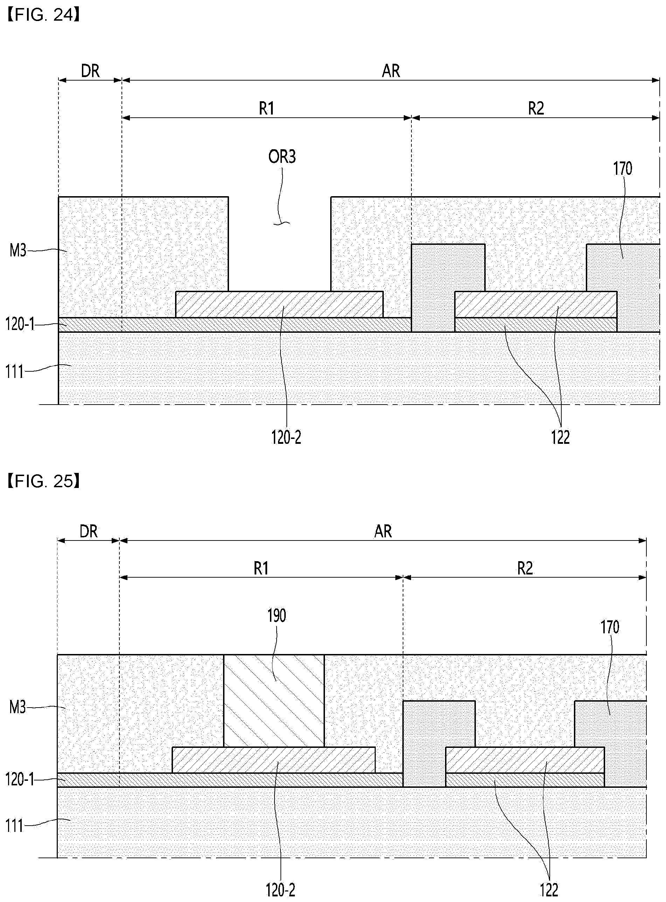

Next, referring to FIG. 24, the embodiment can proceed with a process of forming a third mask M3. The third mask M3 can be entirely disposed on the dummy region DR and the effective region AR and may include an open area OR3 vertically overlapping a portion of the upper surface of the second metal layer 120-2 located in the first region R1. A width of the open region OR3 can be smaller than a width of the second metal layer 120-2 of the first region R1. Accordingly, the third mask M3 can partially open the upper surface of the second metal layer 120-2 of the first region R1.

Next, referring to FIG. 25, the embodiment can proceed with a process of forming a post 190 on the second metal layer 120-2 of the first region R1 opened through the open region OR3 of the third mask M3. At this time, the post 190 can be formed by electroplating the first metal layer 120-1 disposed in the first region R1 and the first metal layer 120-1 disposed in the dummy region DR as a seed layer.

Specifically, the first region R1 is disposed to surround the second region R2. In addition, the dummy region DR is disposed to surround the first region R1. In addition, the first metal layer 120-1 in the first region R1 and the first metal layer 120-1 in the dummy region DR are not removed and remain. Accordingly, the first metal layer 120-1 of the dummy region DR, the first metal layer 120-1 of the first region R1, and the second metal layer 120-2 of the first region R1 are electrically connected to each other. Accordingly, electrolytic plating can be performed on the second metal layer 120-2 to form a post 190 that fills the open region OR3 of the third mask M3.

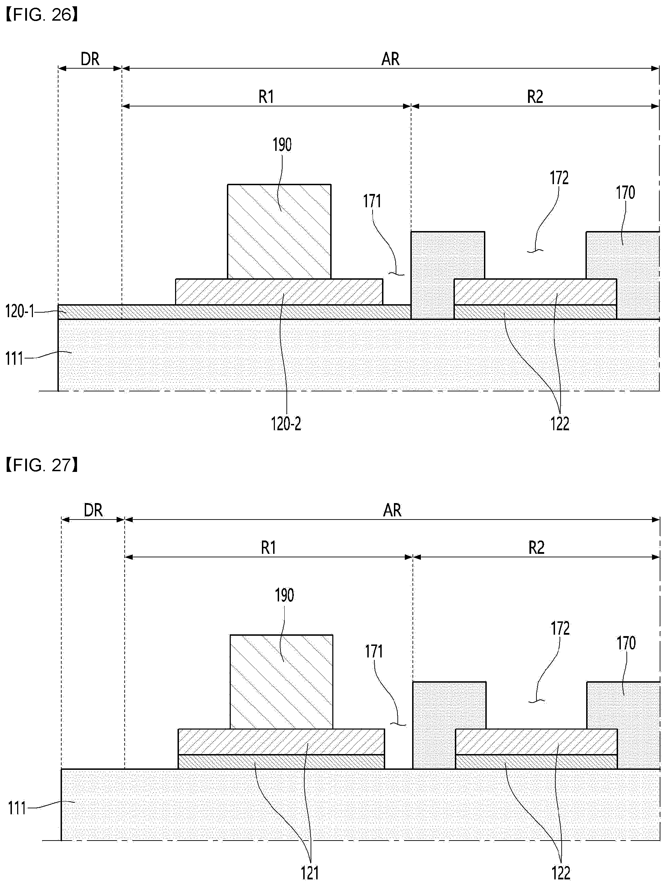

Next, referring to FIG. 26, the embodiment can perform a process of removing the third mask M3. Through this, the first metal layer 120-1 in the first region R1 and the first metal layer 120-1 in the dummy region DR can be opened. At this time, if the resist layer 170R is not removed from a part of the dummy region DR adjacent to the first region R1 (i.e., the third region R3), the first metal layer 120-1 of the third region R3 cannot be opened.

Next, referring to FIG. 27, the embodiment can form the first pad 121 of the first circuit layer 120 by removing the first metal layer 120-1 opened in the first region R1 and the dummy region DR by etching. At this time, if the resist layer 170R remains in the third region R3, the first metal layer 120-1 disposed in the third region R3 may not be removed.

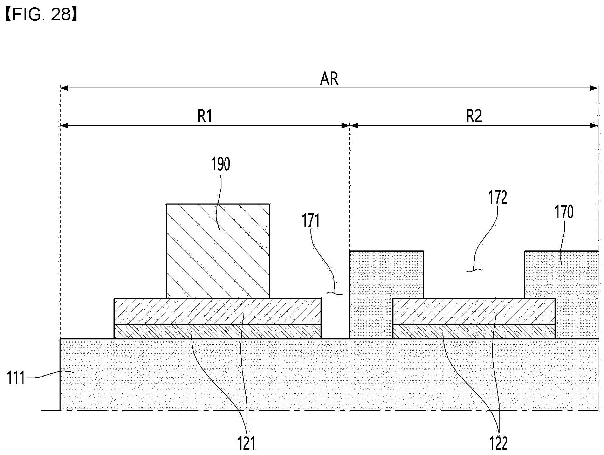

Next, referring to FIG. 28, the embodiment may separate the effective region AR from the dummy region DR by using a line between the dummy region DR and the first region R1 as a sawing line. Through this, the circuit board 100 may be manufactured.

At this time, if the first metal layer 120-1 and the resist layer 170R remain in the third region R3, the sawing line may be between the dummy region DR and the third region R3. Accordingly, as in the fourth embodiment, a dummy pattern 123 corresponding to the first metal layer 120-1 in the third region R3 and a dummy protective layer corresponding to the resist layer 170R on the dummy pattern 123 can be formed. At this time, in a final circuit board, a part of the dummy region DR can be included in the effective region AR.

The characteristics, structures and effects described in the embodiments above are included in at least one embodiment but are not limited to one embodiment. Furthermore, the characteristic, structure, and effect illustrated in each embodiment may be combined or modified for other embodiments by a person skilled in the art. Thus, it would be construed that contents related to such a combination and such a modification are included in the scope of the present invention.

Embodiments are mostly described above. However, they are only examples and do not limit the present invention. A person skilled in the art may appreciate that several variations and applications not presented above may be made without departing from the essential characteristic of embodiments. For example, each component particularly represented in the embodiments may be varied. In addition, it should be construed that differences related to such a variation and such an application are included in the scope of the present invention defined in the following claims.

## Claims

1. A circuit board comprising:
an insulating layer;
a protective member disposed on the insulating layer; and
a plurality of posts disposed on the insulating layer along a circumference of the protective member,
wherein the protective member includes an upper surface, a lower surface, and a side surface disposed between the upper surface and the lower surface,
wherein the lower surface of the protective member faces an upper surface of the insulating layer,
wherein side surfaces of the plurality of posts face the side surface of the protective member, and
wherein the side surface of the protective member includes a protruding portion protruding between the plurality of posts.

2. The circuit board of claim 1, wherein the side surface of the protective member includes a first side surface extending in a first direction, a second side surface extending in the first direction and spaced apart from the first side surface, a third side surface extending in a second direction perpendicular to the first direction, and a fourth side surface extending in the second direction and spaced apart from the third side surface,
wherein the protruding surface of the protective member is provided on the first side surface and the third side surface.

3. The circuit board of claim 2, wherein the third side surface includes a first surface having a first separation distance with the plurality of posts along the first direction, a second surface having a second separation distance smaller than the first separation distance, and a third surface having a third separation distance greater than the first separation distance.

4. The circuit board of claim 2, wherein a separation distance along the first direction between the fourth side surface and the plurality of posts is uniform.

5. The circuit board of claim 2, wherein the second side surface of the protective member includes a concave surface concave toward the first side surface of the protective member.

6. The circuit board of claim 1, wherein the protective member includes a plurality of through holes, and
wherein a width of the plurality of through holes is smaller than a width of the post.

7. The circuit board of claim 1, further comprising:
an outer protective member disposed on the insulating layer and having a through hole, and
wherein the post and the protective member are disposed in the through hole of the outer protective member.

8. The circuit board of claim 6, further comprising:
a surface treatment layer disposed on the post.

9. The circuit board of claim 8, further comprising:
a plurality of pads disposed between the insulating layer and the protective member,
wherein the widths of the plurality of through holes of the protective member are smaller than widths of the plurality of pads, and
wherein the width of the post is smaller than the width of the pad.

10. **11.** The circuit board of claim 9, further comprising:
a surface treatment layer disposed on each of the plurality of through holes of the protective member, and
wherein the surface treatment layer disposed on each of the plurality of through holes of the protective member and the surface treatment layer disposed on the post are provided with a same material.
